# EUROPEAN PATENT APPLICATION

(11) **EP 4 815 659 A2**
(43) Date of publication of application: **30.09.2026**
(21) Application number: 26197793.8
(22) Date of filing: 01.12.2022
(51) Int. Cl.: H10B 80/00

(54) **SEMICONDUCTOR PACKAGE**

(30) Priority: 01.12.2021 KR 20210170023
(62) Document number(s) of the earlier application(s) in accordance with Art. 76 EPC: 22901823.9 / 4 443 501
(71) Applicant: LG Innotek Co., Ltd., Seoul 07796 (KR)
(72) Inventor: CHOE, Yu Lim, 07796 SEOUL (KR); KANG, Tae Gyu, 07796 SEOUL (KR); LEE, Dong Keon, 07796 SEOUL (KR)
(74) Representative: Plasseraud IP

(57) **Abstract**

A semiconductor package according to an embodiment includes a first insulating layer including a cavity; a connection member buried in the cavity of the first insulating layer; and a molding layer buried in the cavity and surrounding the connection member, wherein a width of the molding layer gradually decreases along a direction from a lower surface of the first insulating layer to an upper surface of the first insulating layer.

## Description

### [Technical Field]

An embodiment relates to a semiconductor package, and particularly relates to a semiconductor package including a circuit board and a connection member.

### [Background Art]

Higher performance of electric/electronic products is progressing, and accordingly, technologies for attaching a larger number of packages to a substrate of a limited size are being proposed and researched. However, a general package is based on mounting one semiconductor device, and thus, there is a limit to obtaining desired performance.

A general semiconductor package has a form in which a processor package in which a processor chip is disposed and a memory package in which a memory chip is attached are connected as one. A semiconductor package is provided a processor chip and a memory chip as one integrated package, and thus has advantages of reducing a mounting area of the chip and enabling high-speed signals through a short path.

The semiconductor package as described above has the advantages, it is widely applied to mobile devices and the like.

On the other hand, a size of a package has recently increased due to high specification of an electronic device such as a mobile device and adoption of HBM (High Bandwidth Memory), and accordingly, a semiconductor package including an interposer is mainly used. In this case, the interposer is provided with a silicon substrate.

However, when an interposer such as a silicon substrate is applied, there are problems in that a cost for manufacturing the interposer is high and formation of a Through Silicon Via (TSV) is complicated.

In addition, a conventional semiconductor package includes a connection member such as a silicon-based interconnect bridge. When a silicon-based interconnect bridge is applied, there is a reliability issue due to a mismatch in coefficient of thermal expansion (CTE) between a silicon material of the bridge and an organic material of the substrate, and there is a problem of deterioration of power integrity characteristics.

In addition, a connection member applied to a conventional semiconductor package is manufactured by an etching process, and thus, a pad portion of the connection member has a higher surface roughness than a pad portion manufactured by a plating process. Through this, a connection member applied to a conventional semiconductor package has a problem in that it is difficult to apply to a high frequency. For example, a conventional connection member has a problem of high signal loss due to skin effect when transmitting a high frequency signal due to high surface roughness of a pad portion.

### [Disclosure]

### [Technical Problem]

The embodiment provides a semiconductor package having a novel structure.

In addition, the embodiment provides a semiconductor package capable of transmitting signals in a high frequency band.

In addition, the embodiment provides a semiconductor package in which adhesion between an insulating layer and a pad portion is improved.

In addition, the embodiment provides a semiconductor package in which a plurality of semiconductor devices are mounted side by side in a horizontal direction.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A semiconductor package according to an embodiment comprises a first insulating layer including a cavity; a connection member buried in the cavity of the first insulating layer; and a molding layer buried in the cavity and surrounding the connection member, wherein a width of the molding layer gradually decreases along a direction from a lower surface of the first insulating layer to an upper surface of the first insulating layer.

In addition, the semiconductor package further comprises a first circuit pattern disposed on the first insulating layer and including a first electrode pattern overlapping the connection member in a vertical direction and a second electrode pattern not overlapping the connection member in the vertical direction; a post bump disposed on the second electrode pattern of the first circuit pattern; and a through electrode buried in the first insulating layer, overlapped with the connection member in a horizontal direction, and overlapped with the post bump in a vertical direction; wherein the connection member has a pad portion connected to the first electrode pattern, and wherein a width of the through electrode is greater than a width of the pad portion.

In addition, a width of the through electrode changes in the vertical direction, and the width of the pad portion is smaller than a width of a region having a smallest width in an entire region of the through electrode.

In addition, a width of the first electrode pattern is smaller than a width of the second electrode pattern.

In addition, the pad portion of the connection member includes a first metal layer; a second metal layer disposed on the first metal layer; and a third metal layer disposed on the second metal layer; wherein a lower surface of the third metal layer includes a first portion in contact with the second metal layer and a second portion not in contact with the second metal layer.

In addition, a width of the lower surface of the third metal layer is greater than a width of an upper surface of the second metal layer.

In addition, a width of an upper surface of the third metal layer is greater than a width of an upper surface of the third metal layer.

In addition, a width of the third metal layer increases from a lower surface of the third metal layer toward an upper surface of the third metal layer.

In addition, the connection member includes an insulating member having a concave-convex surface protruding toward the third metal layer.

In addition, the second portion of the lower surface of the third metal layer does not contact the concave-convex surface of the insulating member.

In addition, a height of the concave-convex surface corresponds to a surface roughness value of an upper surface of the insulating member.

In addition, the surface roughness value satisfies a range of 8 nm to 40 nm.

In addition, a thickness of the first metal layer has a range of 30 nm to 100 nm, wherein a thickness of the second metal layer has a range of 100 nm to 500 nm, and wherein a thickness of the third metal layer has a range of 2um to 7um.

In addition, the thickness of the third metal layer satisfies a range of 75% to 98% of a thickness of the pad portion.

In addition, a surface roughness of at least one of an upper surface and a side surface of the third metal layer is smaller than a surface roughness of each of a side surface of the first metal layer and a side surface of the second metal layer.

In addition, the first metal layer includes a first metal material, and wherein the second and third metal layers include a second metal material different from the first metal material.

In addition, the first metal material of the first metal layer includes titanium, and the second metal material of the second and third metal layers includes copper.

In addition, the pad portion includes a lower surface, wherein the lower surface of the pad portion includes a stepped portion, and wherein the stepped portion is provided at an outer side portion of the lower surface of the pad portion.

In addition, the connection member includes an insulating member and a first metal layer disposed between the insulating member and the pad portion, and wherein the first metal layer does not vertically overlap the stepped portion.

In addition, a lower surface of the pad portion includes a first portion in contact with the first metal layer and a second portion not in contact with the first metal layer by the stepped portion.

### [Advantageous Effects]

A semiconductor package according to an embodiment may include a connection member.

The connection member may include an insulating layer and a circuit pattern layer disposed on the insulating layer. The circuit pattern layer may include a first metal layer, a second metal layer, and a third metal layer. In this case, the circuit pattern layer may include a recess or a stepped portion provided in a region corresponding to the first metal layer and the second metal layer. Accordingly, a lower surface of the third metal layer of the circuit pattern layer may have a step. A region corresponding to an outer side portion of the lower surface of the third metal layer may not contact an upper surface of the insulating layer. For example, an outer portion of a lower surface of the third metal layer may not contact a concave-convex surface formed on an upper surface of the insulating layer. An additional laminated insulating layer or molding layer may be formed between an outer side portion of the lower surface of the third metal layer and the concave-convex surface. Accordingly, the embodiment can solve the physical reliability problem that the circuit pattern layer is separated from the insulating layer while miniaturizing the line width or space of the circuit pattern layer included in the connection member. In addition, the third metal layer of the circuit pattern layer according to the embodiment may be formed by electroplating the first metal layer and the second metal layer as a seed layer. Accordingly, a surface roughness of a side surface and an upper surface of the third metal layer may be smaller than that of a metal layer formed by the etching method. Through this, the embodiment can reduce a surface roughness of the third metal layer, accordingly, it is possible to minimize a signal transmission loss caused by a skin effect when transmitting a signal of a high frequency band, and thereby improve signal characteristics.

A circuit board of the embodiment may include a first insulating layer and a second insulating layer. The first insulating layer may include a reinforcing member, and the second insulating layer may not include a reinforcing member. In the embodiment, the circuit design of the circuit board can be performed using the number of layers of the second insulating layer while minimizing the number of layers of the first insulating layer. Accordingly, the embodiment can improve a warpage property of the circuit board by using the first insulating layer and reduce a thickness of the circuit board by using the second insulating layer. Through this, the embodiment can reduce a thickness of a circuit board, reduce a thickness of a semiconductor package, and reduce a thickness of an electronic product and/or server to which the semiconductor package is applied. In addition, according to the embodiment, semiconductor devices and connection members may be stably disposed on a circuit board. Accordingly, the embodiment can stably operate a semiconductor device, and furthermore, stably operate an electronic product and/or a server.

In addition, the embodiment may include a first circuit pattern in which at least a portion is buried in upper surface of the first insulating layer. The first circuit pattern may include first and second pads on which semiconductor devices are mounted. In this case, the first pad and the second pad may be used as mounting pads for mounting the first and second semiconductor devices and may be used as terminal pads connected to connection members. Accordingly, the embodiment can reduce a signal transmission distance between the semiconductor device and the connection member, thereby minimizing the signal transmission loss.

In addition, the embodiment may allow at least a portion of a side surface of the first circuit pattern to be supported by a first insulating layer including a reinforcing member. Accordingly, the embodiment can improve an adhesion strength between the first circuit pattern and the first insulating layer, and further improve product reliability.

In addition, a connection member provided in a conventional semiconductor package may be provided in a buried state in a circuit board. For example, a conventional connection member may be embedded in a circuit board. In this case, bending of the connection member may occur according to the warpage property of the circuit board, and thus reliability of the connection member may deteriorate. For example, a coefficient of thermal expansion of the connection member may be different from that of the circuit board, and cracks may occur due to this. Therefore, it causes damage to the fine circuit layer provided on the connection member. In contrast, the connection member of the embodiment may be protected by the first molding layer while being disposed in the first cavity. Furthermore, an additional insulating layer and a circuit pattern may not be provided below the connection member. Accordingly, the embodiment may improve the warpage property of the connection member in various use environments of the circuit board. Accordingly, the embodiment may improve communication performance between the first and second semiconductor devices. In addition, the embodiment may allow at least a portion of the connection member to be exposed to a lower side of the first molding layer. Accordingly, the embodiment can easily dissipate heat generated from the connection member to an outside, thereby improving heat dissipation characteristics of the connection member. Furthermore, the embodiment can improve physical reliability and electrical reliability of the connection member.

In addition, the embodiment may include a second molding layer to protect a post bump and a third molding layer to protect the semiconductor device. The second and third molding layers may include different insulating materials and may have different strengths. Accordingly, the embodiment may stably protect the post bump and the semiconductor device. In addition, the embodiment may allow a process for manufacturing a circuit board to proceed in a state in which the second molding layer is formed. Accordingly, the embodiment can protect the circuit board from being damaged when the connection member is mounted, and further improve connection reliability between the circuit board and the connection member.

### [Description of Drawings]

FIG. 1 is a cross-sectional view showing a circuit board according to a first embodiment.
FIG. 2 is a view for explaining some components shown in FIG. 1.
FIG. 3 is a view showing a layer structure of a circuit pattern constituting a first insulating layer shown in FIG. 2 in detail.
FIG. 4 is a view for explaining a pad of the first circuit pattern shown in FIG. 2.
FIG. 5 is a view for explaining a post bump shown in FIG. 1.
FIG. 6 is a view showing a connection member of an embodiment.
FIG. 7 is a view showing a detailed structure of a redistribution layer of the connection member shown in FIG. 6.
FIG. 8 is an enlarged view of a specific region of the connection member shown in FIG. 7.
FIGS. 9A to 9H are views for explaining a method of manufacturing a connection member according to an embodiment in a process order.
FIGS. 10A to 10V are views for explaining a method of manufacturing a circuit board shown in FIG. 1 in a process order.
FIG. 11 is a view showing a first semiconductor package according to an embodiment.
FIG. 12 is a view showing a second semiconductor package according to an embodiment.

### [Best Mode]

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and replaced.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C". Further, in describing the elements of the embodiments of the present disclosure, the terms such as first, second, A, B, (a), and (b) may be used.

These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

An embodiment provides a connection member capable of transmitting a signal in a high frequency band, and provides a circuit board and a semiconductor package including the connection member.

In addition, the embodiment provides a semiconductor package in which a plurality of semiconductor devices are mounted on one substrate.

In addition, the embodiment provides a semiconductor package capable of implementing a fine pitch using post bumps and removing an interposer.

### -Electronic device-

Before describing an embodiment, an electronic device to which a semiconductor package of the embodiment is applied will be briefly described. An electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor device in the form of an integrated circuit (IC) in which hundreds to millions of devices are integrated into a single chip. The semiconductor device may be a logic chip, a memory chip, or the like. The logic chip may be a central processor (CPU), a graphic processor (GPU), or the like. For example, the logic chip may be an application processor (AP) semiconductor device including at least one of a central processor (CPU), a graphic processor (GPU), a digital signal processor, a cryptographic processor, a microprocessor, and a microcontroller, or an analog-to-digital converter, an application-specific IC (ASIC), etc., or a chip set that includes a specific combination of those listed so far.

The memory chip may be a stack memory such as HBM. Also, the memory chip may include a memory chip such as a volatile memory (eg, DRAM), a non-volatile memory (eg, ROM), or a flash memory.

On the other hand, A product group to which the semiconductor package of the embodiment is applied include CSP (Chip Scale Package), FC-CSP (Flip Chip-Chip Scale Package), FC-BGA (Flip Chip Ball Grid Array), POP (Package On Package), and SIP ( System In Package), but is not limited thereto.

In this case, the electronic device may include a smart phone, a personal digital assistant, a digital video camera, a digital still camera, a network system, a computer, a monitor, a tablet, a laptop, a netbook, a television, a video game, a smart watch, an automotive, and the like. However, the embodiment is not limited thereto, and may be any other electronic device that processes data in addition to these.

### -embodiment-

Hereinafter, a circuit board according to an embodiment and a semiconductor package including the circuit board will be described in detail.

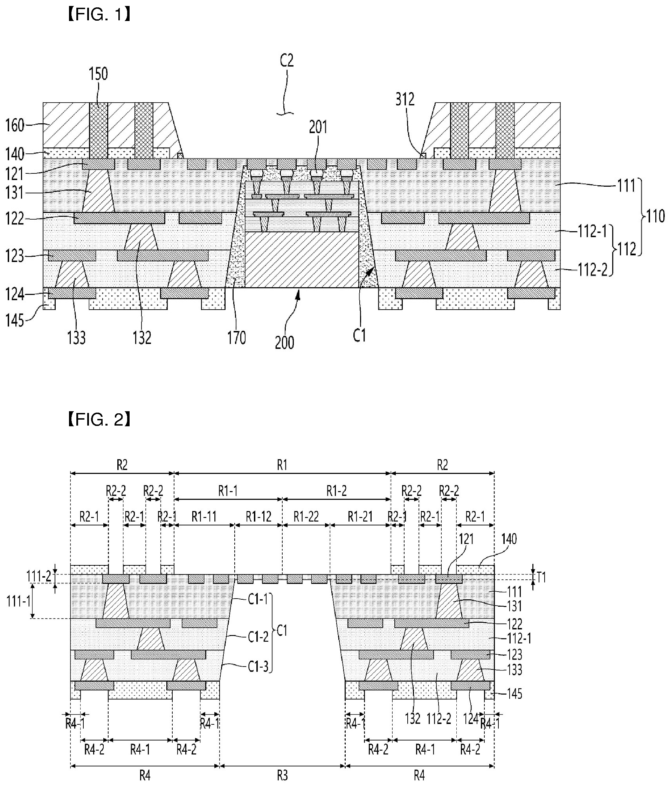

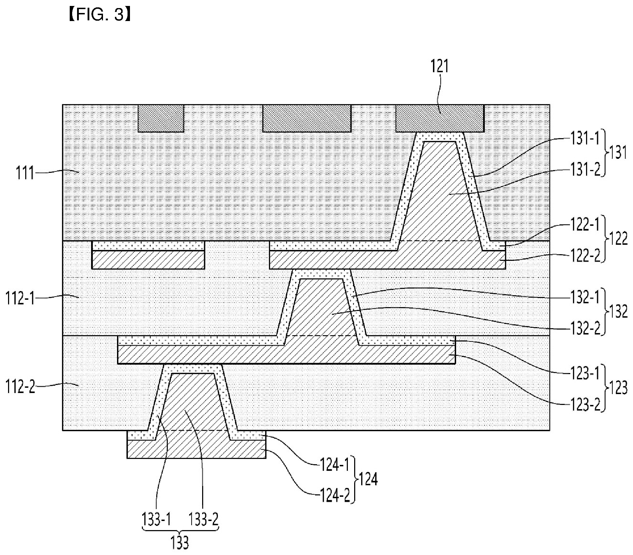

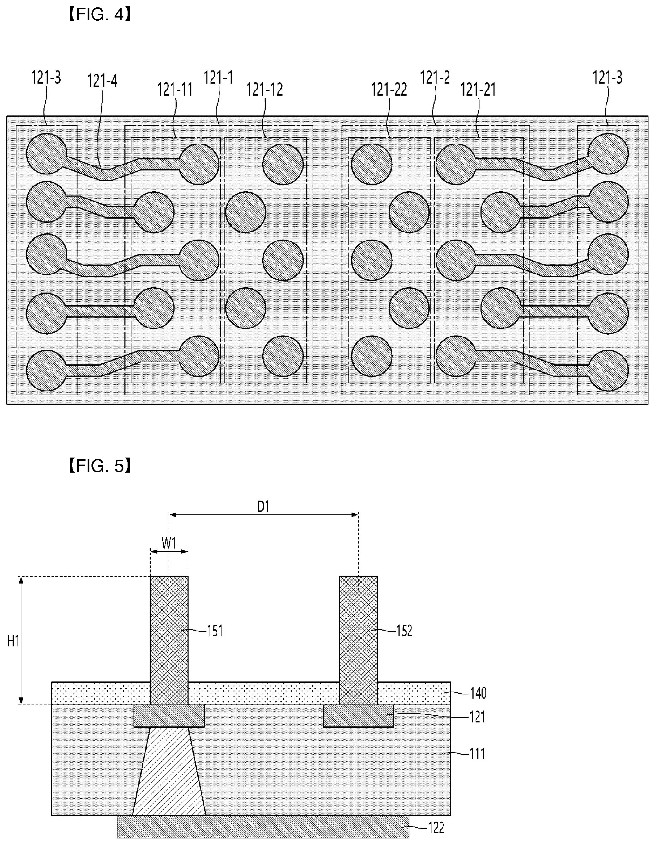

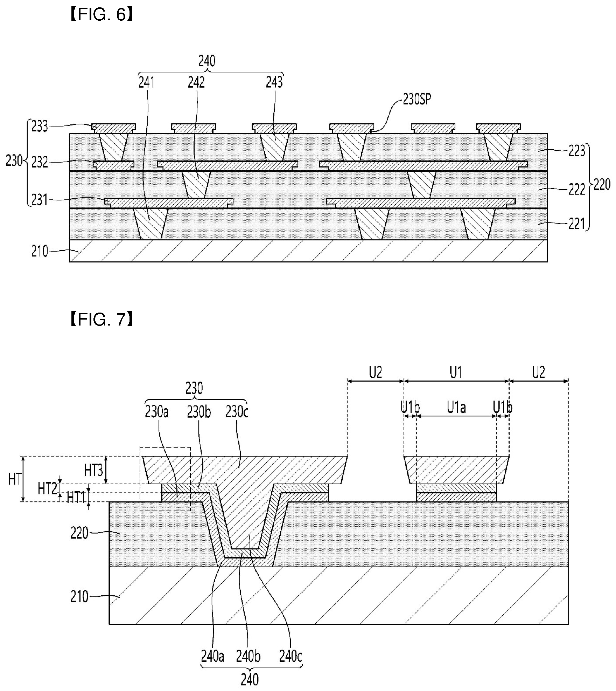

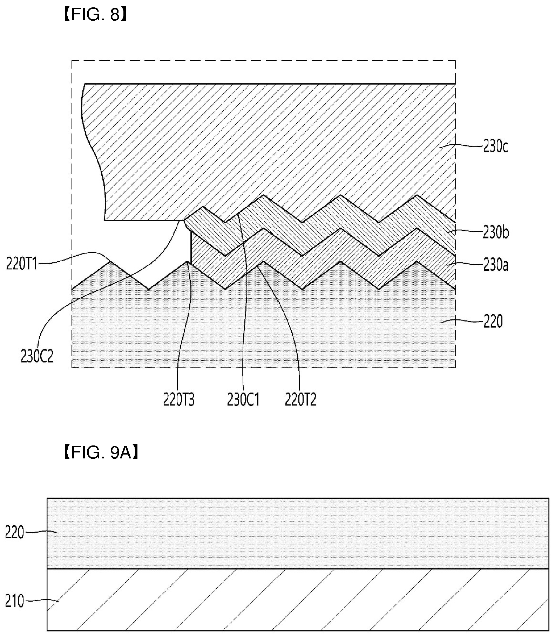

FIG. 1 is a cross-sectional view showing a circuit board according to a first embodiment, FIG. 2 is a view for explaining some components shown in FIG. 1, FIG. 3 is a view showing a layer structure of a circuit pattern constituting a first insulating layer shown in FIG. 2 in detail, FIG. 4 is a view for explaining a pad of the first circuit pattern shown in FIG. 2, FIG. 5 is a view for explaining a post bump shown in FIG. 1, and FIG. 6 is a view showing a connection member of an embodiment, FIG. 7 is a view showing a detailed structure of a redistribution layer of the connection member shown in FIG. 6, and FIG. 8 is an enlarged view of a specific region of the connection member shown in FIG. 7.

Hereinafter, a circuit board according to the first embodiment and a connection member disposed in the circuit board will be described with reference to FIGS. 1 to 8. Before describing the embodiment, a connection member described below may mean a bridge or a bridge substrate. For example, the connection member may include an organic bridge including a redistribution layer.

The circuit board may include a first cavity C1. A connection member 200 may be disposed in the first cavity C1 of the circuit board. The connection member 200 may be referred to as a redistribution substrate, a bridge substrate, or a fine pattern substrate.

The circuit board may include an insulating layer 110. The insulating layer 110 may include a plurality of layers. For example, the insulating layer 110 may include a plurality of layers including different insulating materials.

For example, the insulating layer 110 of the circuit board may include a first insulating layer 111 including a first insulating material. For example, the insulating layer 110 of the circuit board may include a second insulating layer 112 including a second insulating material different from the first insulating material.

The circuit board of the first embodiment can mount at least two different semiconductor devices. For example, the circuit board of the first embodiment can mount at least two processor chips. For example, the circuit board may provide a first mounting region where a CPU is mounted and a second mounting region where a GPU is mounted. In this case, the first mounting region and the second mounting region may be arranged side by side in a horizontal direction at an outermost side of the circuit board. For example, the circuit board of the embodiment may allow the CPU and GPU to be mounted side by side at positions spaced apart from each other by a predetermined space in the horizontal direction.

The first insulating layer 111 of the circuit board may have a one-layer structure. However, the embodiment is not limited thereto, and the first insulating layer 111 may have a layer structure of at least two layers. However, the embodiment makes it possible to reduce a thickness of the semiconductor package, and for this purpose, the first insulating layer 111 may have a one-layer structure.

In this case, a thickness of the first insulating layer 111 of the circuit board may be greater than a thickness of the second insulating layer 112 of the circuit board. The embodiment minimizes the number of layers of the first insulating layer 111 and increases the number of layers of the second insulating layer 112 according to circuit layout design. Through this, it may be possible to slim down the circuit board.

The first insulating layer 111 may provide a mounting region in which a semiconductor device is mounted.

The circuit board of the embodiment may include a second insulating layer 112 disposed under a lower surface of the first insulating layer 111. The second insulating layer 112 may be composed of one layer, or may have a multilayer structure of two or more layers.

An outermost side of the second insulating layer 112 may be connected to a main board of an electronic device, and may include a terminal pad region for connection with the main board.

The first insulating layer 111 may include a first insulating material. For example, the first insulating layer 111 may include a reinforcing member. For example, the first insulating layer 111 may include a prepreg. The reinforcing member may be a glass fiber.

The insulating layer of the circuit board may include the first insulating layer 111 including a reinforcing member, and through this, physical and electrical reliability may be improved while reducing a thickness of the circuit board. For example, when the insulating layer of the circuit board does not include a reinforcing member, cracks may occur in the circuit board, warpage characteristics may deteriorate, and semiconductor devices may not be stably supported.

Accordingly, the circuit board of the embodiment may include the first insulating layer 111 of the first insulating material in which at least one insulating layer among the plurality of insulating layers includes a reinforcing member. Furthermore, the circuit board of the embodiment may have a cavity (C1, C2).

In this case, upper and lower surfaces of a mounting pad on which the semiconductor device is mounted may not contact the first insulating layer and the second insulating layer of the circuit board. In addition, a side surface of the mounting pad may be surrounded by the first insulating layer 111. Therefore, the embodiment allows the mounting pad to be stably supported in a process of forming the cavity C1 and C2, and so that the connection member and the semiconductor device can be stably supported.

That, the first insulating layer 111 may be formed by impregnating a fiber layer in the form of a fabric sheet, such as a glass fabric woven with glass yarn, with an epoxy resin, and then performing thermocompression. However, the embodiment is not limited thereto, and the first insulating layer 111 may include a fiber layer in the form of a fabric sheet woven with carbon fiber yarn.

The first insulating layer 111 may include a resin and a reinforcing member disposed in the resin. The resin may be an epoxy resin, but is not limited thereto. The resin is not particularly limited to the epoxy resin, and for example, one or more epoxy groups may be included in the molecule, or alternatively, two or more epoxy groups may be included, or alternatively, four or more epoxy groups may be included. In addition, the resin 110 may include a naphthalene group, for example, may be an aromatic amine type, but is not limited thereto. For example, the resin may be include a bisphenol A type epoxy resin, a bisphenol F type epoxy resin, a bisphenol S type epoxy resin, a phenol novolac type epoxy resin, an alkylphenol novolac type epoxy resin, a biphenyl type epoxy resin, an aralkyl type epoxy resin, dicyclopentadiene type epoxy resin, naphthalene type epoxy resin, naphthol type epoxy resin, epoxy resin of condensate of phenol and aromatic aldehyde having phenolic hydroxyl group, biphenyl aralkyl type epoxy resin, fluorene type epoxy resin resins, xanthene-type epoxy resins, triglycidyl isocyanurate, rubber-modified epoxy resins, phosphorous-based epoxy resins, and the like, and naphthalene-based epoxy resins, bisphenol A-type epoxy resins, and phenol novolac epoxy resins, cresol novolak epoxy resins, rubber-modified epoxy resins, and phosphorous-based epoxy resins. In addition, the reinforcing member may include glass fiber, carbon fiber, aramid fiber (eg, aramid-based organic material), nylon, silica-based inorganic material or titania-based inorganic material. The reinforcing member may be arranged in the resin to cross each other in a planar direction.

Meanwhile, the reinforcing member may use a glass fiber, a carbon fiber, aramid fiber (eg, aramid-based organic material), a nylon, a silica-based inorganic material or a titania-based inorganic material.

Meanwhile, the first insulating layer 111 may be disposed on a first outermost side of the circuit board. The first outermost side may correspond to a region in which a semiconductor device is mounted. For example, the first outermost side may mean an uppermost side of the circuit board, and thus the first insulating layer 111 means the insulating layer disposed on an uppermost side among the plurality of insulating layers constituting the circuit board.

The first insulating layer 111 may have a thickness ranging from 10 µm to 30 µm. For example, the first insulating layer 111 may have a thickness ranging from 15 µm to 25 µm. For example, the first insulating layer 111 may have a thickness ranging from 18 µm to 23 µm. When the thickness of the first insulating layer 111 is less than 10 µm, the circuit pattern may not be stably disposed on the upper or lower surface of the first insulating layer 111. In addition, when the thickness of the first insulating layer 111 is less than 10 µm, the warpage property of the circuit board according to the embodiment may be deteriorated, and thus physical reliability or electrical reliability may be deteriorated. In addition, when the thickness of the first insulating layer 111 exceeds 30 µm, an overall thickness of the circuit board may increase. In addition, when the thickness of the first insulating layer 111 exceeds 30 µm, the line width or space of circuit patterns formed on the upper or lower surface of the first insulating layer 111 may increase.

Meanwhile, a thickness of the first insulating layer 111 may mean a vertical distance between circuit patterns respectively disposed on the upper and lower surfaces of the first insulating layer 111. For example, the thickness of the first insulating layer 111 may mean a vertical distance between a lower surface of a first circuit pattern 121 and an upper surface of a second circuit pattern 122.

A second insulating layer 112 may be disposed under a lower surface of the first insulating layer 111. The second insulating layer 112 may have a two-layer structure.

The second insulating layer 112 may include a second insulating material different from the first insulating material constituting the first insulating layer 111. For example, the second insulating layer 112 may be made of a resin that does not contain glass fibers. For example, the second insulating layer 112 may be RCC (Resin Coated Copper).

The second insulating layer 112 may include a first layer 112-1 disposed under the lower surface of the first insulating layer 111 and a second layer 112-2 disposed under a lower surface of the first layer 112-1.

A thickness of each of the first layer 112-1 and the second layer 112-2 may be smaller than that of the first insulating layer 111.

For example, each of the first layer 112-1 and the second layer 112-2 may have a thickness of 8 µm to 20 µm. For example, each of the first layer 112-1 and the second layer 112-2 may have a thickness of 8.5 µm to 17 µm. For example, each of the first layer 112-1 and the second layer 112-2 may have a thickness of 9 µm to 15 µm.

The thickness of the first layer 112-1 may mean a distance between a lower surface of a second circuit pattern 122 and an upper surface of a third circuit pattern 123. In addition, the thickness of the second layer 112-2 may mean a distance between a lower surface of a third circuit pattern 123 and an upper surface of a fourth circuit pattern 124.

When the thickness of the first layer 112-1 and the second layer 112-2 is less than 8 µm, it may be difficult to stably arrange the circuit pattern, and the warpage property of the circuit board may deteriorate. When the thickness of the first layer 112-1 and the second layer 112-2 exceeds 20 µm, the line width or space of the circuit pattern may increase, and the thickness of the circuit board may increase.

The embodiment allows the remaining insulating layers except for the first insulating layer 111 of the first layer to be provided as the second insulating layer of the RCC, so that it is possible to improve communication performance while reducing the overall thickness of the circuit board.

That is, the embodiment allows the second insulating layer 112 to be provided as an RCC having a low dielectric constant, so that it is possible to provide a highly reliable circuit board in which signal loss is minimized even in a high frequency band while reducing the thickness of the circuit board.

Meanwhile, the second insulating layer 112 is not limited to the RCC, and may include other insulating materials that do not include glass fibers. For example, the second insulating layer 112 may include a photocurable resin or a photosensitive resin. For example, the second insulating layer 112 may include photo imageable dielectics (PID). In addition, the second insulating layer 112 may use ABF (Ajinomoto Build-up Film) as a product released by Ajinomoto.

An upper side of the first insulating layer 111 may include a device mounting region in which a plurality of semiconductor devices are mounted. For example, the upper side of the first insulating layer 111 may include a first region R1 on which a semiconductor device is mounted and a second region R1 other than the first region R1.

The first region R1 may include a first-first region R1-1 in which a first semiconductor device is mounted and a first-second region R1-2 in which a second semiconductor device is mounted. In addition, each of the first-first region R1-1 and the first-second region R1-2 may be divided into a plurality of regions. The first-first region R1-1 may include a first-first sub-region R1-11 and a first-second sub-region R1-12. The first-second region R1-2 may include a second-first sub-region R1-21 and a second-second sub-region R1-22.

That is, the first and second semiconductor devices may include terminals electrically connected to each other. For example, the first and second semiconductor devices may include a first-first terminal to be electrically connected and a first-second terminal other than this. In addition, the second semiconductor device may include a second-first terminal electrically connected to the first semiconductor device and a second-second terminal other than this terminal.

The first-first sub-region R1-11 is a region in which a mounting pad connected to a first-second terminal among terminals of the first semiconductor device is disposed, and the first-second sub-region R1-12 is a region in which a mounting pad connected to a first-first terminal among terminals of the first semiconductor device are disposed.

Correspondingly, the second-first sub-region R1-21 is a region in which a mounting pad connected to the second-second terminal among the terminals of the second semiconductor device is disposed, and the second-second sub-region R1-22 is a region in which a mounting pad connected to the second-first terminal among the terminals of the second semiconductor device is disposed
In addition, a first protective layer 140 may be disposed on the second region R2 of the first insulating layer 111. In this case, the first protective layer 140 may include an opening (not shown) exposing an upper surface of the first circuit pattern 121 disposed on an upper surface of the first insulating layer 111.

Accordingly, the second region R2 of the first insulating layer 111 may include a second-first region R2-1 in which the first protective layer 140 is disposed, and a second-second region R2-2 corresponding to the opening of the first protective layer 140.

In addition, a lower surface of the second insulating layer 112 may include a third region R3 and a fourth region R4.

That is, the lower surface of the second insulating layer 112 can be divided into a region where the connection member 200 is disposed and the other region except for this region. For example, a lower surface of the second insulating layer 112 may be divided into a region where the second protective layer 145 is disposed and the other region except for this region. The third region R3 of the second insulating layer 112 may mean a region where the connection member 200 is disposed and a region where the second protective layer 145 is not disposed. In addition, the fourth region R4 of the second insulating layer 112 may mean a region in which the connection member 200 is not disposed or a region in which the second protective layer 145 is disposed. Meanwhile, the second protective layer 145 may be included an opening (not shown) exposing a lower surface of the fourth circuit pattern 124 disposed under a lower surface of the second insulating layer 112 (specifically, the lower surface of the second layer 112-2). Accordingly, the fourth region R4 of the second insulating layer 112 may include a fourth-first region R4-1 in which the second protective layer 145 is disposed, and a fourth-second region R4-2 corresponding to the opening of the second protective layer 145.

The circuit board of the embodiment may include a circuit pattern disposed on a surface of each insulating layer.

For example, the embodiment may include a first circuit pattern 121, a second circuit pattern 122, a third circuit pattern 123, and a fourth circuit pattern 124.

In this case, the circuit board of the embodiment forms a circuit pattern by applying the ETS method, and accordingly, a circuit pattern disposed on an outermost side of the circuit board may have an embedded trace substrate (ETS) structure. For example, a circuit pattern disposed on a first outermost side among the circuit pattern included in the circuit board may have a structure buried in an insulating layer, and a circuit pattern disposed on a second outermost side opposite to the first outermost side may have a structure protruding from a surface of the insulating layer.

The first circuit pattern 121 may be disposed on an upper surface of the first insulating layer 111.

The first circuit pattern 121 may be a circuit pattern disposed in a region where a semiconductor device is to be mounted. The first circuit pattern 121 may have an ETS structure. For example, the first circuit pattern 121 may have a structure buried in an upper surface of the first insulating layer 111. For example, an upper surface of the first circuit pattern 121 and the upper surface of the first insulating layer 111 may be positioned on the same plane. However, the embodiment is not limited thereto. For example, an upper surface of the first circuit pattern 121 may be positioned higher than an upper surface of the first insulating layer 111. This may be achieved by etching at least a portion of the upper surface of the first insulating layer 111 after the manufacturing of the first circuit pattern 121 is completed.

Side and lower surfaces of the first circuit pattern 121 may be covered by the first insulating layer 111. However, a lower surface of some of the first circuit patterns 121 may be exposed through a first cavity C1 to be described later.

The first circuit pattern 121 may include a mounting pad on which a semiconductor device is mounted. The first circuit pattern 121 has an ETS structure and may be buried in a region adjacent to an upper surface of the first insulating layer 111. Such an ETS structure may enable miniaturization of a circuit pattern compared to a structure protruding above an insulating layer. Accordingly, the embodiment allows miniaturization of mounting pads or traces in the mounting region of the semiconductor device, so that it is possible to easily mount the first and second semiconductor devices.

The second circuit pattern 122 may be disposed under a lower surface of the first insulating layer 111. For example, the second circuit pattern 122 may be disposed between the lower surface of the first insulating layer 111 and the upper surface of the first layer 112-1 of the second insulating layer 112. The second circuit pattern 122 may protrude downward from the lower surface of the first insulating layer 111. Side and lower surfaces of the second circuit pattern 122 may be covered by the first layer 112-1.

The third circuit pattern 123 may be disposed on the lower surface of the first layer 112-1. For example, the third circuit pattern 123 may be disposed between the lower surface of the first layer 112-1 and the upper surface of the second layer 112-2. The third circuit pattern 123 may protrude downward from the lower surface of the first layer 112-1. Side and lower surfaces of the third circuit pattern 123 may be covered by the second layer 112-2.

The fourth circuit pattern 124 may be disposed on a lower surface of the second layer 112-2. The fourth circuit pattern 124 may be a circuit pattern disposed under a second outermost side of the circuit pattern 121. For example, the fourth circuit pattern 124 may be a circuit pattern disposed under a lowermost side of the circuit board. The fourth circuit pattern 124 may include a pad. A pad of the fourth circuit pattern 124 may be a terminal pad connected to a main board of an electronic device.

The first pattern layer 121, the second pattern layer 122, the third circuit pattern 123, and the fourth circuit pattern 124 may be formed of at least one metal material selected from gold (Au), silver (Ag), platinum (Pt), titanium (Ti), tin (Sn), copper (Cu), and zinc (Zn). In addition, the first pattern layer 121, the second pattern layer 122, the third circuit pattern 123, and the fourth circuit pattern 124 may be formed of a paste or solder paste including at least one metal material selected from among gold (Au), silver (Ag), platinum (Pt), titanium (Ti), tin (Sn), copper (Cu), and zinc (Zn) having excellent bonding strength. Preferably, the first pattern layer 121, the second pattern layer 122, the third circuit pattern 123, and the fourth circuit pattern 124 may be formed of copper (Cu), which has high electrical conductivity and is relatively inexpensive.

The first circuit pattern 121, the second circuit pattern 122, the third circuit pattern 123, and the fourth circuit pattern 124 may have different thicknesses. For example, a part of the first circuit pattern 121, the second circuit pattern 122, the third circuit pattern 123, and the fourth circuit pattern 124 is disposed on the first insulating layer 111 made of prepreg, and the remaining part is disposed on the second insulating layer 112 composed of RCC. Accordingly, a thickness of the circuit pattern disposed on the first insulating layer 111 and a thickness of the circuit pattern disposed on the second insulating layer 112 may be different. For example, a thickness of the circuit pattern 121 disposed on the first insulating layer 111 may be greater than a thickness of the circuit pattern disposed on the second insulating layer 112.

The first circuit pattern 121 and the second circuit pattern 122 may have a thickness ranging from 10 µm to 25 µm. For example, the first circuit pattern 121 and the second circuit pattern 122 may have a thickness ranging from 12 µm to 22 µm. For example, the first circuit pattern 121 and the second circuit pattern 122 may have a thickness ranging from 13 µm to 18 µm.

When the thickness of the first circuit pattern 121 and the second circuit pattern 122 is less than 10 µm, a resistance of the first circuit pattern 121 and the second circuit pattern 122 may increase. In addition, it may be difficult to form a circuit pattern having a thickness of less than 10 µm on the insulating layer including the prepreg. When the thickness of the first circuit pattern 121 and the second circuit pattern 122 exceeds 25 µm, the line width or space of the first circuit pattern 121 and the second circuit pattern 122 may increase, and accordingly, an overall volume of the circuit board may increase.

The thickness of the third circuit pattern 123 and the fourth circuit pattern 124 may range from 7 µm to 20 µm. For example, the third circuit pattern 123 and the fourth circuit pattern 124 may have a thickness ranging from 8 µm to 17 µm. For example, the third circuit pattern 123 and the fourth circuit pattern 124 may have a thickness ranging from 8 µm to 15 µm.

Each of the first circuit pattern 121, the second circuit pattern 122, the third circuit pattern 123, and the fourth circuit pattern 124 may include a pad and a trace.

The pad may include a mounting pad on which a semiconductor device is mounted, a through electrode pad connected to a through electrode, and a core pad or BGA pad on which an adhesive ball (to be described later) is disposed that is connected to the main board of the electronic device. The trace may refer to a wire in the form of a long line that is connected to the pad and transmits an electrical signal. The

The pads of the first circuit pattern 121, the second circuit pattern 122, the third circuit pattern 123, and the fourth circuit pattern 124 may have a width ranging from 20 µm to 50 µm. The pad of the first circuit pattern 120 may have a width ranging from 22 µm to 40 µm. The pad of the first circuit pattern 120 may have a width ranging from 25 µm to 35 µm.

The traces of the first circuit pattern 121, the second circuit pattern 122, the third circuit pattern 123, and the fourth circuit pattern 124 may have a specific line width and a specific space.

For example, the line width of the traces of the first circuit pattern 121, the second circuit pattern 122, the third circuit pattern 123, and the fourth circuit pattern 124 may have a range of 5 µm to 20 µm. For example, the line width of the traces of the first circuit pattern 121, the second circuit pattern 122, the third circuit pattern 123, and the fourth circuit pattern 124 may have a range of 7 µm to 15 µm. For example, the line width of the first circuit pattern 121, the second circuit pattern 122, the third circuit pattern 123, and the fourth circuit pattern 124 may have a range of 8 µm to 12 µm..

In addition, the space of the traces of the first circuit pattern 121, the second circuit pattern 122, the third circuit pattern 123, and the fourth circuit pattern 124 may have a range of 5 µm to 20 µm. For example, the space of the traces of the first circuit pattern 121, the second circuit pattern 122, the third circuit pattern 123, and the fourth circuit pattern 124 may have a range of 7 µm to 15 µm. For example, the space of the traces of the first circuit pattern 121, the second circuit pattern 122, the third circuit pattern 123, and the fourth circuit pattern 124 may have a range of 8 µm to 12 µm.

Meanwhile, the trace of each of the first circuit pattern 121, the second circuit pattern 122, the third circuit pattern 123, and the fourth circuit pattern 124 may have different line widths and spaces within the above range. For example, the first circuit pattern 121 should be disposed in a region where a semiconductor device is to be mounted and formed into a fine pattern accordingly. In addition, the fourth circuit pattern 124 should be connected to the main board of the electronic device. Accordingly, the fourth circuit pattern 124 must correspond to the standards of wires included in the main board. Accordingly, the trace of the first circuit pattern 121 among the circuit patterns of the embodiment may have the smallest line width and space, and the fourth circuit pattern 124 may have the largest line width and space. In addition, the line width and space of the trace of the third circuit pattern 123 may be greater than the line width and space of the traces of the second circuit pattern 122 and may be smaller than the space and line width of the trace of the fourth circuit pattern 124.

Correspondingly, the pad of the first circuit pattern 121 among the circuit patterns may have a smallest width, and the pad of the fourth circuit pattern 124 may have a largest width. The pad of the second circuit pattern 122 may have a width larger than that of the pad of the first circuit pattern 121 and smaller than that of the pad of the fourth circuit pattern 124. In addition, the pad of the third circuit pattern 123 may have a width larger than that of the pad of the second circuit pattern 122 and smaller than that of the pad of the fourth circuit pattern 124.

Meanwhile, a through electrode may be formed in each of the first insulating layer 111, the first layer 112-1, and the second layer 112-2. The through electrode may electrically connect circuit patterns disposed on the surface of each insulating layer to each other.

A first through electrode 131 may be formed in the first insulating layer 111. A second through electrode 132 may be formed in the first layer 112-1. In addition, a third through electrode 133 may be formed in the second layer 112-2. The first through electrode 131, the second through electrode 132, and the third through electrode 133 include the first insulating layer 111, the first layer 112-1, and the second layer 112-2 can penetrate only one insulating layer among the first insulating layer 111, the first layer 112-1 and the second layer 112-2, or may be formed to pass through at least two insulating layers in common.

The first through electrode 131 may connect a lower surface of the first circuit pattern 121 and an upper surface of the second circuit pattern 122. For example, an upper surface of the first through electrode 131 may be connected to the lower surface of the first circuit pattern 121, and the lower surface of the first through electrode 131 may be connected to the upper surface of the second circuit pattern 122.

The second through electrode 132 may connect a lower surface of the second circuit pattern 122 and an upper surface of the third circuit pattern 123. For example, the upper surface of the second through electrode 132 may be connected to the lower surface of the second circuit pattern 122, and the lower surface of the second through electrode 132 may be connected to the upper surface of the third circuit pattern 123.

The third through electrode 133 may connect a lower surface of the third circuit pattern 123 and an upper surface of the fourth circuit pattern 124. For example, the upper surface of the third through electrode 133 may be connected to the lower surface of the third circuit pattern 123, and the lower surface of the third through electrode 133 may be connected to the upper surface of the fourth circuit pattern 124.

The first through electrode 131, the second through electrode 132, and the third through electrode 133 may have the same shape as each other. For example, the first through electrode 131, the second through electrode 132, and the third through electrode 133 may have a trapezoidal shape in which an upper surface width is smaller than a lower surface width. For example, a width of the upper surface of each of the first through electrode 131, the second through electrode 132, and the third through electrode 133 may be smaller than that of the lower surface of each of the first through electrode 131, the second through electrode 132, and the third through electrode 133.

A width of each of the first through electrode 131, the second through electrode 132, and the third through electrode 133 may satisfy a range of 20 µm to 60 µm. A width of each of the first through electrode 131, the second through electrode 132, and the third through electrode 133 may satisfy a range of 25 µm to 55 µm. A width of each of the first through electrode 131, the second through electrode 132, and the third through electrode 133 may satisfy a range of 28 µm to 50 µm. The width of each of the first through electrode 131, the second through electrode 132, and the third through electrode 133 may mean the width of a relatively wide lower surface of each through electrode.

A width of each of the first through electrode 131, the second through electrode 132, and the third through electrode 133 may be greater than that of a pad portion provided in the connection member 200. For example, the width of the upper surface and the lower surface of each of the first through electrode 131, the second through electrode 132, and the third through electrode 133 may be greater than that of a pad portion provided in the connection member 200. Accordingly, the embodiment can easily connect the connection member 200 and the first and second semiconductor devices, and can easily connect to a third semiconductor device or an external substrate through a post bump.

The first through electrode 131, the second through electrode 132, and the third through electrode 133 may have different widths within the above range. That is, a difference between the widths of the first through electrode 131, the second through electrode 132, and the third through electrode 133 may correspond to a difference in width of pads of the first circuit pattern 121, the second circuit pattern 122, the third circuit pattern 123, and the fourth circuit pattern 124.

For example, a width of the first through electrode 131 may be the smallest among the through electrodes. In addition, a width of the third through electrode 133 may be the largest among the through electrodes. In addition, the width of the second through electrode 132 may be larger than the width of the first through electrode 131 and smaller than the width of the third through electrode 133.

The first through electrode 131, the second through electrode 132, and the third through electrode 133 may be formed by filling a through hole passing through the insulating layer 110 with a conductive material.

The through hole may be formed by any one of mechanical, laser, and chemical processing. When the through hole is formed by machining, it can be formed using methods such as milling, drilling, and routing. When the through hole is formed by laser processing, it can be formed using methods such as UV or CO2 laser. When the through hole is formed by chemical processing, it can be formed using a chemical containing amino silane, ketones, or the like. Accordingly, the embodiment may open at least one insulating layer among the plurality of insulating layers.

Meanwhile, the laser processing is a cutting method that concentrates optical energy on a surface to melt and evaporate a part of the material to take a desired shape, accordingly, complex formations by computer programs can be easily processed, and even composite materials that are difficult to cut by other methods can be processed.

In addition, the laser processing has a cutting diameter of at least 0.005mm, and has the advantage of a wide range of processable thicknesses.

A laser processing drill preferably uses a YAG (Yttrium Aluminum Garnet) laser, a CO2 laser, or an ultraviolet (UV) laser. YAG laser is a laser that can process both copper foil layers and insulating layers, and CO2 laser is a laser that can process only insulating layers.

When the through hole is formed, each through electrode may be formed by filling the inside of the through hole with a conductive material. The metal material forming the through electrode may be any one material selected from copper (Cu), silver (Ag), tin (Sn), gold (Au), nickel (Ni), and palladium (Pd). In addition, the conductive material filling may use any one or a combination of electroless plating, electrolytic plating, screen printing, sputtering, evaporation, ink-jetting and dispensing.

The circuit patterns and the through electrode may have a plurality of layer structures. However, the first circuit pattern 121 of the embodiment has an ETS structure, and thus may have a layer structure different from other circuit patterns.

For example, the first circuit pattern 121 may have a layer structure different from those of the second circuit pattern 122, the third circuit pattern 123, and the fourth circuit pattern 124. For example, a number of layers of the first circuit pattern 121 may be different from that of the second circuit pattern 122, the third circuit pattern 123, and the fourth circuit pattern 124. For example, the number of layers of the first circuit pattern 121 may be smaller than the number of layers of the second circuit pattern 122, the third circuit pattern 123, and the fourth circuit pattern 124.

For example, the first circuit pattern 121 may include only an electrolytic plating layer.

Alternatively, the second circuit pattern 122 may include a seed layer 122-1 and an electrolytic plating layer 122-2. In addition, the third circuit pattern 123 may include a seed layer 123-1 and an electrolytic plating layer 123-2. In addition, the fourth circuit pattern 124 may include a seed layer 124-1 and an electrolytic plating layer 124-2.

That is, the first circuit pattern 121 is a pattern formed first among the circuit patterns of the circuit board, and accordingly, a seed layer of the first circuit pattern 121 may be removed in a final process.

Meanwhile, the first through electrode 131 may include a seed layer 131-1 and an electrolytic plating layer 131-2 corresponding to the second circuit pattern 122. The second through electrode 132 may include a seed layer 132-1 and an electrolytic plating layer 132-2 corresponding to the third circuit pattern 123. The third through electrode 133 may include a seed layer 133-1 and an electrolytic plating layer 133-2 corresponding to the fourth circuit pattern 124.

An embodiment may include a protective layer. That is, the circuit board may include a first protective layer 140 disposed on the upper surface of the first insulating layer 111. The first protective layer 140 may be disposed on the second region R2 of the first insulating layer 111. For example, the first protective layer 140 may be disposed on the second-first region R2-1, and may include an opening exposing the second-second region R2-2 of the second region R2 where the post bump is to be disposed.

In addition, the circuit board may include a second protective layer 145 disposed under a lower surface of the second layer 112-2. The second protective layer 145 may be disposed in the fourth region R4 of the lower surface of the second layer 112-2.

For example, the second protective layer 145 may be disposed under the 4-1 region (R4-1), and may include an opening exposing the 4-2 region (R4-2) of the fourth region (R4) where a connection portion to be connected to the main board of the electronic device is disposed.

Meanwhile, the embodiment may provide a mounting region in which a plurality of first and second semiconductor devices of different types may be mounted on one circuit board.

For example, the first-first region R1-1 in the embodiment is a region in which a first semiconductor device is mounted, and the first-second region R1-2 may be a region in which a second semiconductor device different from the first semiconductor device is mounted. For example, the first semiconductor device may be any one of an application processor (AP) chip such as a central processor (eg, CPU), a graphic processor (eg, GPU), a digital signal processor, a cryptographic processor, a microprocessor, or a microcontroller. The second semiconductor device may be a processor chip of a different type from the first processor chip among an application processor (AP) chip such as a central processor (eg, CPU), a graphic processor (eg, GPU), a digital signal processor, a cryptographic processor, a microprocessor, or a microcontroller. For example, the first semiconductor device may be a central processor chip, and the second semiconductor device may be a graphic processor chip. That is, the circuit board of the embodiment may be a circuit board for a die split in which application processors are separated by function and separate processor chips are mounted on one board for each of the separated functions.

In this case, the die split structure requires a connection between the first semiconductor device and the second semiconductor device. That is, a trace for connecting the first semiconductor device and the second semiconductor device is required in the first circuit pattern 121. In this case, the trace may be required to be ultra-miniaturized for connection between the first and second semiconductor devices within a limited space. For example, the trace may require a line width of 4 µm or less and a space of 4 µm or less.

In this case, there is a limit to miniaturizing line widths and spaces of traces of circuit patterns formed on the first insulating layer 111 and the second insulating layer 112. Accordingly, the embodiment allows connection between the first semiconductor device and the second semiconductor device using the connection member 200. For example, the connection member 200 may function as a bridge connecting at least some terminals of the first semiconductor device and at least some terminals of the second semiconductor device.

To this end, the circuit board may include a first cavity C1. In addition, a connection member 200 may be inserted or disposed in the first cavity C1.

In this case, the first cavity C1 into which the connection member 200 is inserted or disposed may vertically overlap the lower surface of the pattern disposed in the first region R1 among the first circuit pattern 121. A lower surface of the pattern disposed in the first region R1 among the first circuit patterns 121 may be exposed through the first cavity C1 in a state before the connection member 200 is disposed.

Before explaining the connection member 200, the first circuit pattern 121 disposed on the upper surface of the first insulating layer 111 will be described in more detail.

The first circuit pattern 121 may include a plurality of pads. The pad may also be referred to as an electrode pattern.

The first circuit pattern 121 may include a first pad 121-1 disposed in a first-first region R1-1 on which the first semiconductor device is mounted.

The first pad 121-1 includes a first-first pad 121-11 disposed in a first-first sub-region R1-11 and a first-second pad 121-12 disposed in a first-second sub-region R1-12. The first-second pad 121-12 may be disposed in a region overlapping the first cavity C1 in a thickness direction. Accordingly, a lower surface of the first-second pad 121-12 may be exposed through the first cavity C1. An upper surface of the first-second pad 121-12 may be a portion where the first semiconductor device is mounted, and the lower surface may be a portion to which the connection member 200 is attached.

In addition, the first circuit pattern 121 may include a second pad 121-2 disposed in a first-second region R1-2 where the second semiconductor device is mounted.

The second pad 121-2 includes a second-first pad 121-21 disposed in the second-first sub-region R1-21 and a second-second pad 121-22 disposed in the second-second sub-region R1-22. In addition, the second-second pad 121-22 are disposed in a region overlapping the first cavity C1 in the thickness direction. Accordingly, a lower surface of the second-second pad 121-22 may be exposed through the first cavity C1 in a state before the connection member 200 is disposed. An upper surface of the second-second pad 121-22 may be a portion where the second semiconductor device is mounted, and a lower surface may be a portion to which the connection member 200 is attached.

The first-second pad 121-12 and the second-second pad 121-22 may be a connection pad of the first pad 121-1 and the second pad 121-2 to be connected to each other.

The first circuit pattern 121 further includes a third pad 121-3 on which a post bump 150 is disposed. The third pad 121-3 may be disposed on the second-second region R2-2 of the first insulating layer 111. That is, the third pad 121-3 may be exposed through the opening of the first protective layer 140.

In addition, the first circuit pattern 121 may include a trace 121-4. The traces 121-4 may connect a pad of the first circuit pattern 121 to each other.

Meanwhile, in the embodiment, the first-second pad 121-12 and the second-second pad 121-22 may be electrically connected using the connection member 200. The first-second pad 121-12 of the first pad 121-1 to be connected to the second semiconductor device may be disposed adjacent to the second pad 121-2. Furthermore, in an embodiment, the second-second pad 121-22 of the second pad 121-2 to be connected to the first semiconductor device may be disposed adjacent to the first pad 121-1. Therefore, the first-second pad 121-12 and the second-second pad 121-22 of the embodiment may be disposed adjacent to each other.

Meanwhile, a post bump 150 may be disposed at a predetermined height on the third pad 121-3. In the comparative example, the first package and the second package were connected using a second adhesive ball 13. In this case, pitch matching between the first package and the second package may be difficult due to the limitation of the pitch of the second adhesive balls 13. Therefore, the comparative example additionally required a second substrate 15. In contrast, in the embodiment, the first package and the second package may be connected using the post bump 150. In this case, even if the post bumps 150 are formed at a height higher than a certain level compared to the second adhesive balls 13, rigidity may be secured, and a pitch between the plurality of post bumps may be refined.

In this case, the post bump 150 may have a certain width W1 and height H1. A width W1 of the post bump 150 may be 20 µm to 50 µm. For example, the width W1 of the post bump 150 may be 25 µm to 45 µm. For example, the width W1 of the post bump 150 may be 28 µm to 40 µm. When the width W1 of the post bump 150 is less than 20 µm, the post bump 150 may be easily broken due to low rigidity. For example, when the width W1 of the post bump 150 is less than 20 µm, the post bump 150 may not have the height H1.

The height H1 of the post bump 150 may be 60 µm to 150 µm. For example, the height H1 of the post bump 150 may be 70 µm to 135 µm. For example, the height H1 of the post bump 150 may be 90 µm to 120 µm. When the height H1 of the post bump 150 is smaller than 60 µm, a semiconductor device mounted on the circuit board may be damaged in a process of attaching a memory package later. When the height H1 of the post bump 150 is greater than 150 µm, the thickness of the circuit pattern 121 may increase. In addition, when the height H1 of the post bump 150 is greater than 150 µm, the width W1 of the post bump 150 must be increased for this purpose, and accordingly, a pitch D1 of the post bump 150 can increase.

The post bump 150 may have a certain level of pitch D1. For example, the post bump 150 may include a first post bump 151 and a second post bump 152 adjacent to each other. In addition, the pitch D1 may mean a distance between a center of the first post bump 151 and a center of the second post bump 152. The pitch D1 may have a range of 20 µm to 80 µm. For example, the pitch D1 may have a range of 25 µm to 70 µm. For example, the pitch D1 may have a range of 30 µm to 60 µm. When the pitch D1 is smaller than 20 µm, adjacent post bumps may be connected to each other, and thus a reliability problem such as a circuit short may occur. Also, when the pitch D1 is greater than 80 µm, a second substrate may be additionally required to connect (eg, pitch matching) between a plurality of semiconductor devices.

Meanwhile, the insulating layer 110 of the embodiment includes a first cavity C1, and the connection member 200 may be inserted and/or buried in the first cavity C1.

The first cavity C1 may include a first portion C1-1 formed in the first insulating layer 111, a second portion C1-2 formed in the first layer 112-1, and a third portion C1-3 formed in the second layer 112-2. In this case, an inclination of an inner wall of the first portion C1-1 may be different from an inclination of inner walls of the second portion C1-2 and the third portion C1-3. For example, the inclination of the inner wall of the first portion C1-1 may be greater than the inclination of the second portion C1-2 and the third portion C1-3. That is, the first portion (C1-1) is formed in the first insulating layer 111 including prepreg, and accordingly, it may be larger than the inclination of the inner walls of the second portion C1-2 and the third portion C1-3 formed ion the second insulating layer 112 including the RCC.

The first-second pad 121-12 and the second-second pad 121 - 22 of In the first circuit pattern 121 may overlap the first cavity C1 in a thickness direction or a vertical direction.

Meanwhile, the first insulating layer 111 may include a first portion 111-1 disposed between the first circuit pattern 121 and the second circuit pattern 122 and a second portion surrounding the first circuit pattern 121. In this case, a thickness of the first insulating layer 111 may mean a thickness of the first portion 111-1.

In this case, in the embodiment, the first cavity C1 may open a portion of the second portion 111-2 of the first insulating layer 111. Accordingly, the second portion 111-2 of the first insulating layer 111 may have different thicknesses for each region. For example, the second portion 111-2 of the first insulating layer 111 may include a second-first portion overlapping the first cavity C1 in the thickness direction and a second-second portion other than the second-first portion. A thickness of the second-second portion may be substantially the same as that of the first circuit pattern 121. Alternatively, the second-first portion overlapping the first cavity C1 may be less than a thickness of the first circuit pattern 121, furthermore, a thickness of each of the first-second pad 121-12 and second-second pad 121-22. For example, the thickness T1 of the second-first portion overlapping the first cavity C1 in the first insulating layer 111 may be smaller than the thickness of the first-second pad 121-12 and the second-second pad 121-22.

Here, the insulating layer 110 of the embodiment may include a first cavity C1 for disposing the connection member 200. In this case, the first cavity C1 may be formed to substantially pass through the insulating layer 110. Here, the first-second pad 121-12 and the second-second pad 121-22 may be supported through the second-first portion of the first insulating layer 111. In this case, a thickness T1 of the second-first portion of the first insulating layer 111 may be smaller than that of the first-second pad 121-12 and the second-second pad 121-22. Accordingly, the first cavity C1 is formed, and accordingly, the first-second pad 121-12 and the second-second pad 121-22 may not be stably supported. In this case, the embodiment allows to stably support the first-second pad 121-12 and the second-second pad 121-22 with a minimum thickness wile securing the rigidity of the circuit board and improving the warpage property. Accordingly, the first insulating layer 111 may include a reinforcing member. According to the embodiment, even if the first cavity C1 is provided, the first-second pad 121-12 and the second-second pad 121-22 can be stably supported, thereby improving reliability.

Meanwhile, a first connection portion 201 may be disposed under lower surfaces of the first-second pad 121-12 and second-second pad 121-22 exposed through the first cavity C1. The connection member 200 may be attached to the first-second pad 121-12 and the second-second pad 121-22 in the first cavity C1 through the first connection portion 201.

The connection member 200 may electrically connect the first-second pad 121-12 and the second-second pad 121-22. For example, the connection member 200 may electrically connect the first and second semiconductor devices to each other through the first-second pad 121-12 and the second-second pad 121-22. For example, the connection member 200 may perform die to die interconnection for electrically connecting a plurality of semiconductor devices mounted on a circuit board to each other. The plurality of semiconductor devices must be electrically connected to each other within a limited space. In addition, a very dense connection circuit is required within a limited space in order to connect the plurality of semiconductor devices. Accordingly, the connection member 200 of the embodiment includes a high-density circuit layer, and thus can electrically connect a plurality of semiconductor devices mounted on the circuit board.

Hereinafter, the connection member 200 will be described in detail.

The connection member 200 may include a base layer 210, an insulating layer 220, a circuit pattern layer 230, and a through electrode 240. The circuit pattern layer 230 of the connection member 200 according to the embodiment may be an ultra-miniature pattern. For example, the circuit pattern layer 230 of the embodiment may connect the first and second semiconductor devices. In this case, the circuit pattern layer 230 may also be referred to as a pattern portion, a wiring portion, a pad portion, an electrode portion, and the like. A line width of the pad portion of the circuit pattern layer 230 according to the embodiment may satisfy a range of 1 µm to 8 µm. For example, the line width of the pad portion of the circuit pattern layer 230 according to the embodiment may satisfy a range of 1.2 µm to 6.5 µm. For example, the line width of the pad portion of the circuit pattern layer 230 according to the embodiment may satisfy a range of 1.5 µm to 5 µm. In addition, a space between a plurality of neighboring pad portions of the circuit pattern layer 230 according to the embodiment may satisfy a range of 1 µm to 8 µm. For example, a space between a plurality of neighboring pad portions of the circuit pattern layer 230 according to the embodiment may satisfy a range of 1.2 µm to 6.5 µm. For example, a space between a plurality of neighboring pad portions of the circuit pattern layer 230 according to the embodiment may satisfy a range of 1.5 µm to 5 µm. This can be achieved by material properties of an insulating layer 220 constituting the connection member 200 and a layer structure of the circuit pattern layer 230. This will be described in detail.

The base layer 210 may improve warpage property of the connection member 200. For example, the base layer 210 may support the connection member 200. To this end, the base layer 210 may include silicon (Si), glass, ceramic, or the like. However, embodiments are not limited thereto. For example, the base layer 210 may be composed of an organic layer such as polyimide (PI) or SiO2.

The insulating layer 220 of the connection member 200 may be stacked on one surface of the base layer 210. For example, the insulating layer 220 of the connection member 200 may be disposed on an upper surface of the base layer 210. The insulating layer 220 of the connection member 200 may include a photosensitive resin. For example, the insulating layer 220 of the connection member 200 may include a PID.

The insulating layer 220 of the connection member 200 may have a multi-layer structure. The insulating layer 220 of the connection member 200 may also be referred to as an insulating member.

For example, the insulating layer 220 of the connection member 200 may include a first insulating layer 221, a second insulating layer 222, and a third insulating layer 223 sequentially disposed on the base layer 210.

In addition, a circuit pattern layer 230 may be disposed on an upper surface of the insulating layer 220 of the connection member 200. In addition, a through electrode 240 may be disposed in the insulating layer 220 of the connection member 200.

Preferably, the circuit pattern layer 230 may include a first circuit pattern layer 231 disposed on an upper surface of the first insulating layer 221. In addition, the circuit pattern layer 230 may include a second circuit pattern layer 232 disposed on the upper surface of the second insulating layer 222. In addition, the circuit pattern layer 230 may include a third circuit pattern layer 233 disposed on an upper surface of the third insulating layer 223.

In addition, the through electrode 240 may include a first through electrode 241 disposed in the first insulating layer 221. In addition, the through electrode 240 may include a second through electrode 242 disposed in the second insulating layer 222. In addition, the through electrode 240 may include a third through electrode 243 disposed in the third insulating layer 223.

In this case, the first circuit pattern layer 231, the second circuit pattern layer 232, and the third circuit pattern layer 233 may have the same layer structure. Accordingly, hereinafter, it will be referred to as a circuit pattern layer 230 as a whole. In addition, the first through electrode 241, the second through electrode 242, and the third through electrode 243 may have the same layer structure. Accordingly, hereinafter, it will be referred as a through electrode 240 as a whole.

Each of the circuit pattern layer 230 and through electrode 240 may have a multi-layer structure. For example, the circuit pattern layer 230 may have a three-layer structure. Also, the through electrode 240 may have a three-layer structure corresponding to the circuit pattern layer 230.

For example, the circuit pattern layer 230 may include a first metal layer 230a disposed on the insulating layer 220. In addition, the circuit pattern layer 230 may include a second metal layer 230b disposed on the first metal layer 230a. In addition, the circuit pattern layer 230 may include a third metal layer 230c disposed on the second metal layer 230b.

In addition, the through electrode 240 may include a first metal layer 240a disposed on an inner wall of a through hole (not shown) of the insulating layer 220. In addition, the through electrode 240 may include a second metal layer 240b disposed on the first metal layer 240a in the through hole of the insulating layer 220. In addition, the through electrode 240 may be disposed on the second metal layer 240b of the through electrode 240 while filling the through hole of the insulating layer 220.

In this case, the first metal layer 230a of the circuit pattern layer 230 and the first metal layer 240a of the through electrode 240 are substantially the same layer, and may be distinguished according to components. In addition, the second metal layer 230b of the circuit pattern layer 230 and the second metal layer 240b of the through electrode 240 are substantially the same layer, and may be distinguished according to components. In addition, the third metal layer 230c of the circuit pattern layer 230 and the third metal layer 240c of the through electrode 240 are substantially the same layer, and may be distinguished according to components..

Accordingly, hereinafter, only the first metal layer 230a, the second metal layer 230b, and the third metal layer 230c of the circuit pattern layer 230 will be described.

The first metal layer 230a of the circuit pattern layer 230 may be disposed on the insulating layer 220. In this case, the first metal layer 230a may be a metal layer formed through sputtering. However, the embodiment is not limited thereto, and the first metal layer 230a may be formed by applying a method other than sputtering. The first metal layer 230a may include titanium (Ti).

The first metal layer 230a may be formed on the insulating layer 220 to have a first thickness HT1. For example, the first metal layer 230a may have a first thickness HT1 ranging from 30 nm to 100 nm. For example, the first metal layer 230a may have a first thickness HT1 ranging from 32 nm to 98 nm. For example, the first metal layer 230a may have a first thickness HT1 ranging from 34 nm to 95 nm. When the first thickness HT1 of the first metal layer 230a is less than 30 nm, the first metal layer 230a may not be formed to a uniform thickness on the insulating layer 220. For example, when the first thickness HT1 of the first metal layer 230a is less than 30 nm, a problem may occur in that the first metal layer 230a is not formed in at least a portion of the upper surface of the insulating layer 220. When the first thickness HT1 of the first metal layer 230a is greater than 100 nm, an overall thickness of the circuit pattern layer 230 increases, and accordingly, the line width or space of the circuit pattern layer 230 may not be ultra-miniaturized within the above-described range.

The second metal layer 230b may be disposed on the first metal layer 230a. The second metal layer 230b may be a metal layer formed through sputtering. However, the embodiment is not limited thereto, and the second metal layer 230b may be formed by applying a method other than sputtering. The second metal layer 230b may include copper (Cu).

The second metal layer 230b may be formed to have a second thickness HT2 on the first metal layer 230a. For example, the second metal layer 230b may have a second thickness HT2 ranging from 100 nm to 500 nm. For example, the second metal layer 230b may have a second thickness HT2 ranging from 105 nm to 495 nm. For example, the second metal layer 230b may have a second thickness HT2 ranging from 110 nm to 490 nm. When the second thickness HT2 of the second metal layer 230b is less than 100 nm, the third metal layer 230c may not be stably formed on the second metal layer 230b. When the second thickness HT2 of the second metal layer 230b is less than 100 nm, the second metal layer 230b may not be formed with a uniform thickness on the first metal layer 230a. When the second thickness HT2 of the second metal layer 230b exceeds 500 nm, a total thickness HT of the circuit pattern layer 230 increases, and accordingly, it may be difficult to make the line width or space of the circuit pattern layer 230 ultra-fine.

The third metal layer 230c may be disposed on the second metal layer 230b. The third metal layer 230c may be a metal layer formed through plating. For example, the third metal layer 230c may be an electrolytic plating layer formed by electroplating the first metal layer 230a and the second metal layer 230b as seed layers. The third metal layer 230c may include copper (Cu).

The third metal layer 230c may be formed on the second metal layer 230b to have a third thickness HT3. For example, the third metal layer 230c may have a third thickness HT3 ranging from 2 µm to 7 µm. For example, the third metal layer 230c may have a third thickness HT3 ranging from 2.5 µm to 6.8 µm. For example, the third metal layer 230c may have a third thickness HT3 ranging from 2.8 µm to 6.5 µm. The third thickness HT3 of the third metal layer 230c may be determined based on a total thickness HT of the circuit pattern layer 230. Preferably, the third thickness HT3 of the third metal layer 230c satisfies a range of 75% to 98% of a total thickness HT of the circuit pattern layer 230. For example, the third thickness HT3 of the third metal layer 230c satisfies a range of 78% to 95% of the total thickness HT of the circuit pattern layer 230. For example, the third thickness HT3 of the third metal layer 230c satisfies a range of 80% to 93% of the total thickness HT of the circuit pattern layer 230.

When the third thickness HT3 of the third metal layer 230c is less than 2 µm or less than 75% of the total thickness HT, the circuit pattern layer 230 may be detached from the insulating layer 220 due to the stepped portion or recess portion 230U formed in the circuit pattern layer 230. When the third thickness HT3 of the third metal layer 230c exceeds 7 µm or exceeds 98% of the total thickness HT, a thickness of the first metal layer 230a or the second metal layer 230b decreases correspondingly, and so that physical or electrical reliability problems as described above may occur. When the third thickness HT3 of the third metal layer 230c exceeds 7 µm or exceeds 98% of the total thickness HT, the thickness of the circuit pattern layer 230 increases, and accordingly, it may be difficult to make the line width or space of the circuit pattern layer 230 ultra-fine.

Meanwhile, the third metal layer 230c may be a metal layer formed by electroplating and not being etched. Accordingly, a surface roughness of the upper and side surfaces of the third metal layer 230c may have a lower value than a surface roughness of a side surface of the first metal layer 230a or a side surface of the second metal layer 230b. The third metal layer 230c may have a third thickness HT3 ranging from 75% to 98% of the total thickness HT of the circuit pattern layer 230, and accordingly, the surface roughness of the circuit pattern layer 230 may have a value corresponding to the surface roughness of the upper or side surface of the third metal layer 230c. Accordingly, the embodiment may form the circuit pattern layer 230 of the third metal layer 230c having a relatively low surface roughness value, so that it is possible to minimize signal transmission loss due to the skin effect that occurs when transmitting a high frequency signal.

The surface roughness may refer to a surface roughness of a cross section observed when measured with a scanning electron microscope at an energy of 20 Kv or more.

Meanwhile, the upper surface of the insulating layer 220 may include a concave-convex surface. Preferably, the upper surface of the insulating layer 220 may be provided a surface roughness of a certain level or higher. That is, a surface roughness capable of securing adhesion to the first metal layer 230a may be provided to the upper surface of the insulating layer 220. For example, the upper surface of the insulating layer 220 may have a surface roughness capable of minimizing a skin effect problem that occurs as the surface roughness of the circuit pattern layer 230 increases.

For example, a surface roughness of the upper surface of the insulating layer 220 may have a range of 8 nm to 40 nm. The surface roughness of the upper surface of the insulating layer 220 may correspond to a height of a concave-convex surface provided on an upper surface of the insulating layer 220.

When the surface roughness or the height of the concave-convex surface of the upper surface of the insulating layer 220 is smaller than 8 nm, the adhesion between the insulating layer 220 and the circuit pattern layer 230 is reduced, and accordingly, a physical reliability problem in which the circuit pattern layer 230 is separated by the insulating layer 220 may occur. In addition, when the surface roughness of the upper surface of the insulating layer 220 or the height of the concave-convex surface is greater than 40 nm, the surface roughness of the lower surface of the circuit pattern layer 230 increases, and accordingly signal transmission loss due to the skin effect may increase. That is, the lower surface of the circuit pattern layer 230 has a surface roughness corresponding to the surface roughness of the upper surface of the insulating layer 220 or the height of the concave-convex surface. That is, the first metal layer 230a formed on the upper surface of the insulating layer 220 is formed along the surface roughness of the upper surface of the insulating layer 220 or the concave-convex surface, and accordingly, the insulating layer 220 may have a surface roughness corresponding to the surface roughness of the upper surface. In addition, the surface roughness of the lower surface of the first metal layer 230a increases as the surface roughness of the upper surface of the insulating layer 220 increases, and correspondingly, the surface roughness of the lower surface of the circuit pattern layer 230 increases. In addition, when the surface roughness of the lower surface of the circuit pattern layer 230 increases, a problem in that signal transmission loss due to the skin effect increases, and thus communication characteristics may deteriorate. The embodiment allows the surface roughness of the upper surface of the insulating layer 220 or the height of the concave-convex surface to have a range between 8 nm and 40 nm, and accordingly, signal transmission loss due to a skin effect can be minimized while securing adhesion between the insulating layer 220 and the circuit pattern layer 230.

Meanwhile, the surface roughness of at least a portion of the first region U1 of the upper surface of the insulating layer 220 vertically overlapping the circuit pattern layer 230 may be different from the surface roughness of the second region U2 that does not vertically overlap with the circuit pattern layer 230. For example, the surface roughness of the second region U2 of the upper surface of the insulating layer 220 may be greater than that of the first region U1.

Meanwhile, the circuit pattern layer 230 may include a recess or stepped portion 230U provided in a region adjacent to the upper surface of the insulating layer 220. Accordingly, a width of the lower surface of the circuit pattern layer 230 may be different from that of an upper surface of the circuit pattern layer 230. For example, a width of the circuit pattern layer 230 may increase from the lower surface toward the upper surface.

A recess or stepped portion 230U of the circuit pattern layer 230 may be formed to correspond to the first metal layer 230a and the second metal layer 230b of the circuit pattern layer 230.

For example, the first metal layer 230a of the circuit pattern layer 230 may have a first width. In addition, the second metal layer 230b of the circuit pattern layer 230 may have a second width corresponding to the first width. In addition, the third metal layer 230c of the circuit pattern layer 230 may have a third width greater than the first and second widths. Accordingly, a recess or stepped portion 230U may be formed in a region corresponding to the first metal layer 230a and the second metal layer 230b of the circuit pattern layer 230. In addition, a portion of the third metal layer 230c of the circuit pattern layer 230 adjacent to the second metal layer 230b may be partially removed during an etching process of the second metal layer 230b. Through this, the recess or stepped portion 230U may also be partially formed in a region adjacent to the second metal layer 230b in the second metal layer 230b. However, the embodiment is not limited thereto, and the recess or stepped portion 230U may be formed only in regions corresponding to the first metal layer 230a and the second metal layer 230b of the entire region of the circuit pattern layer 230.

Hereinafter, the insulating layer 220 and the circuit pattern layer 230 as described above will be separately described for each region.

The connection member 200 may include a first region U1 and a second region U2. The first region U1 and the second region U2 may be distinguished by whether the insulating layer 220 and the circuit pattern layer 230 vertically overlap each other.

For example, the upper surface of the insulating layer 220 may include a concave-convex surface. Specifically, the upper surface of the insulating layer 220 may include a concave-convex surface 220T2 and 220T3 corresponding to a first region U1 vertically overlapping the circuit pattern layer 230 and a concave-convex surface 220T1 corresponding to a second region U2 that does not vertically overlap the circuit pattern layer 230. In this case, the concave-convex surface 220T2 and 220T3 corresponding to the first region U1 and the concave-convex surface 220T1 corresponding to the second region U2 may have corresponding heights, or may have different heights. For example, the concave-convex surface in the entire region of the upper surface of the insulating layer 220 may have a height of 8 nm to 40 nm corresponding to the surface roughness of the upper surface of the insulating layer 220.

In this case, at least a portion of the concave-convex surface 220T2 and 220T3 of the first region U1 contacts the circuit pattern layer 230. The concave-convex surface 220T2 in contact with the circuit pattern layer 230 may have a height lower than that of the concave-convex surface 220T3 that does not contact the circuit pattern layer 230. This may cause a change in the height of the concave-convex surface of the imager or a change in the surface roughness of the upper surface of the insulating layer 220 in a process of forming the circuit pattern layer 230 (For example, a process of etching the first metal layer and the second metal layer after they are formed), and accordingly, a difference in surface roughness or concave-convex surface height may occur for each region of the upper surface of the insulating layer 220.

Meanwhile, the concave-convex surface of the upper surface of the insulating layer 220 corresponding to the first region U1 may be divided into a plurality of parts.

For example, the first region U1 may include a first-first region U1a that vertically overlaps the circuit pattern layer 230 and contacts the circuit pattern layer 230. In addition, the first region U1 may include a first-second region U1b that vertically overlaps the circuit pattern layer 230 and does not contact the circuit pattern layer 230. For example, the first-first region U1a may refer to a portion of the circuit pattern layer 230 that directly contacts the first metal layer 230a. For example, the first-second region U1b may mean a portion vertically overlapping a recess or stepped portion 230U of the circuit pattern layer 230.

Accordingly, the concave-convex surface of the upper surface of the insulating layer 220 may include a first concave-convex surface 220T2 that vertically overlaps the circuit pattern layer 230 and directly contacts the circuit pattern layer 230.

In addition, the concave-convex surface of the upper surface of the insulating layer 220 may include a second concave-convex surface 220T3 vertically overlapping the circuit pattern layer 230 and non-contacting the circuit pattern layer 230. In this case, a height of each of the first concave-convex surface 220T2 and the second concave-convex surface 220T3 may be different from each other, but are not limited thereto. However, the second concave-convex surface 220T3 may have a height change as the first metal layer 230a is removed in an etching process after the circuit pattern layer 230 is formed.

In this case, the second concave-convex surface 220T3 of the insulating layer 220 does not contact the circuit pattern layer 230. For example, an uppermost end of the second concave-convex surface 220T3 of the insulating layer 220 may be spaced apart from a lower surface of the circuit pattern layer 230 by a predetermined distance.

Meanwhile, the circuit pattern layer 230 includes the recess or stepped portion 230U, and accordingly, a part of the lower surface of the circuit pattern layer 230 may contact the insulating layer 220 and the remaining part may not contact the insulating layer 220.

Specifically, the width of the lower surface of the third metal layer 230c of the circuit pattern layer 230 may be greater than the width of the upper surface or the lower surface of the second metal layer 230b. In addition, the width of the lower surface of the third metal layer 230c of the circuit pattern layer 230 may be greater than the width of the upper surface or the lower surface of the first metal layer 230a. In addition, a difference between the width of the lower surface of the third metal layer 230c of the circuit pattern layer 230 and a width of each of the first metal layer 230a and the second metal layer 230b may correspond to a horizontal length of the recess or stepped portion 230U.

Meanwhile, the width of the first metal layer 230a may be different from that of the second metal layer 230b. For example, the width of the first metal layer 230a may be smaller than that of the second metal layer 230b. For example, the width of the upper surface of the first metal layer 230a may be smaller than the width of the lower surface of the second metal layer 230b or the width of the upper surface of the second metal layer 230b. In this case, the first metal layer 230a is etched after the second metal layer 230b is etched, and accordingly, the width of the first metal layer 230a finally etched may be the smallest.

Meanwhile, the lower surface of the third metal layer 230c may be divided into a plurality of portions. For example, the lower surface of the third metal layer 230c may include a first portion 230C1 contacting an upper surface of the second metal layer 230b. In addition, the lower surface of the third metal layer 230c may include a second portion 230C2 that does not contact the upper surface of the second metal layer 230b.

The first portion 230C1 of the lower surface of the third metal layer 230c may be farther away from a side surface of the third metal layer 230c than the second portion 230C2 of the lower surface of the third metal layer 230c.

In other words, the second portion 230C2 of the lower surface of the third metal layer 230c may be adjacent to the side surface of the third metal layer 230c. For example, the second portion 230C2 of the lower surface of the third metal layer 230c may be positioned at an outer side portion of an entire region of the lower surface of the third metal layer 230c.

The second portion 230C2 of the lower surface of the third metal layer 230c may not contact the upper surface of the insulating layer 220. Preferably, the second portion 230C2 of the lower surface of the third metal layer 230c may vertically overlap the second concave-convex surface 220T3 of the upper surface of the insulating layer 220. In addition, the second portion 230C2 of the third metal layer 230c may not contact the second concave-convex surface 220T3 of the upper surface of the insulating layer 220.

The third metal layer 230c may include an inclination whose width increases from a lower surface toward an upper surface. For example, a side surface of the third metal layer 230c may have an inclination in which a width increases from a lower surface of the third metal layer 230c to an upper surface. For example, the embodiment uses a mask having a positive characteristic in a process of electroplating the third metal layer 230c, and accordingly, the width of the third metal layer 230c may increase from the lower surface toward the upper surface.

At least a portion of the side surface of the third metal layer 230c may be removed in an etching process of the second metal layer 230b. Through this, a vertical section of the side surface of the third metal layer 230c may include a curved surface. For example, a side surface of the third metal layer 230c may have a curved inclination such that the width increases from the lower surface of the third metal layer 230c toward the upper surface.

Meanwhile, a space between the second portion 230C2 of the third metal layer 230c and the second concave-convex surface 220T3 of the insulating layer 220 may be filled with an additionally stacked insulating layer or a molding layer. Accordingly, the embodiment may allow the additionally stacked insulating layer or molding layer to contact the second portion 230C2 of the lower surface of the third metal layer 230c and the second concave-convex surface 220T3 of the insulating layer 220, and so that it is possible to improve mutual adhesion strength.

Meanwhile, the first metal layer 230a and the second metal layer 230b of the circuit pattern layer 230 may have a relatively smaller thickness than the third metal layer 230c. Accordingly, the third metal layer 230c may be a portion substantially serving as a pad in the circuit pattern layer 230. Accordingly, the second metal layer 230b and the third metal layer 230c of the circuit pattern layer 230 may be referred to as a pad portion. That is, the second metal layer 230b and the third metal layer 230c of the circuit pattern layer 230 include copper of the same metal, and accordingly, the second metal layer 230b and the third metal layer 230c may be referred to as a pad portion. In addition, a recess or stepped portion 230U is provided at a lower surface of the pad portion corresponding to the second metal layer 230b. In addition, the recess or stepped portion (230U) is provided at an outer side portion of the lower surface of the pad portion.

Meanwhile, a connection portion 201 may be disposed on the circuit pattern layer 230 disposed on an uppermost side of the connection member 200.

The connection member 200 may be attached to the first-second pad 121-12 and the second-second pad 121-22 through the first connection portion 201.

As described above, the connection member 200 can be inserted into the first cavity C1, and so that it is possible to easily connect the first-second pad 121-12 and the second-second pad 121-22 within a limited space.

Meanwhile, a first molding layer 170 may be formed in the first cavity C1. The first molding layer 170 may fill the first cavity C1 in a state in which the connection member 200 is inserted and attached in the first cavity C1. That is, the first molding layer 170 may protect the connection member 200 inserted into the first cavity C1. In this case, at least a part of the connection member 200 may be exposed through a lower surface of the first molding layer 170. For example, the base layer 210 of the connection member 200 may be exposed through the lower surface of the first molding layer 170. Accordingly, the embodiment can easily dissipate the heat generated from the connection member 200 to an outside, so that heat dissipation of the connection member 200 can be improved. Furthermore, the embodiment can improve the reliability of the connection member 200, so that communication performance between the first and second semiconductor devices connected through the connection member 200 may be improved. However, the embodiment is not limited thereto. For example, the connection member 200 may be buried in the first molding layer 170.

The first molding layer 170 may include an insulating material. For example, the first molding layer 170 may be made of a normal resin, but is not limited thereto. For example, the first molding layer 170 may be made of non-conductive paste (NCP). For example, the first molding layer 170 may be made of EMC (Epoxy Molding Compound).

Meanwhile, at least one of a recess or stepped portion 230U formed in the circuit pattern layer 230 of the connection member 200 may be filled with the first molding layer 170.

In addition, a connection member provided in a conventional semiconductor package is disposed in a buried state in a circuit board. For example, a connection member of a conventional semiconductor package is buried in a circuit board, and thus has a structure in which an insulating layer and a circuit pattern are disposed on upper and lower portions thereof. In this case, the connection member is bent according to the warpage property of the circuit board, and thus reliability of the connection member may be deteriorated. For example, there is a difference between the thermal expansion coefficient of the circuit board and the thermal expansion coefficient of the connection member, so that cracks may occur in the connection member, and thus damage to the ultrafine circuit layer included in the connection member may occur.

In contrast, the connection member 200 is provided in the first cavity C1 of the circuit board, and may include a first molding layer 170 protecting the connection member. In addition, the insulating layer 110 constituting the circuit board or the circuit patterns are not disposed on a lower side of the connection member 200. Accordingly, reliability can be maintained by improving the warpage property of the connection member 200 in various use environments of the circuit board, and accordingly, communication performance between the first and second semiconductor devices can be improved.

Meanwhile, a second molding layer 160 may be formed on the first insulating layer 111. Preferably, the second molding layer 160 may be formed on the first protective layer 140.

The second molding layer 160 may be disposed on the second region R2 of the first insulating layer 111. The second molding layer 160 may be disposed surrounding the post bump 150. For example, the second molding layer 160 may be a protective layer for protecting the post bump 150.

The second molding layer 160 may include a second cavity C2. For example, the second molding layer 160 may include a second cavity C2 exposing the first region R1 of the first insulating layer 111. For example, the second molding layer 160 may include a second cavity C2 exposing the first pad 121-1 and the second pad 121-2 disposed in the first region R1 among the first circuit pattern 121. Accordingly, upper surfaces of the first pad 121-1 and the second pad 121-2 for mounting the first and second semiconductor devices of the first circuit pattern 121 may be exposed.

Meanwhile, a metal layer 312 may be disposed on an upper surface of the first insulating layer 111. The metal layer 312 may be a seed layer used when forming the first circuit pattern 121. That is, the embodiment allows a portion of the seed layer used to form the first circuit pattern 121 to be used as a laser stopper for forming the second cavity C2.

In addition, it may be difficult to exactly match a size of the metal layer used as the laser stopper and the second cavity C2. Accordingly, a portion of the metal layer 312 may remain between the first insulating layer 111 and the second molding layer 160. However, the embodiment is not limited thereto, and the metal layer 312 may be completely removed through an additional etching process.

A semiconductor package according to an embodiment may include a connection member. The connection member may include an insulating layer and a circuit pattern layer disposed on the insulating layer. The circuit pattern layer may include a first metal layer, a second metal layer, and a third metal layer. In this case, the circuit pattern layer may include a recess or a stepped portion provided in a region corresponding to the first metal layer and the second metal layer. Accordingly, a lower surface of the third metal layer of the circuit pattern layer may have a step. A region corresponding to an outer side portion of the lower surface of the third metal layer may not contact an upper surface of the insulating layer. For example, an outer side portion of a lower surface of the third metal layer may not contact a concave-convex surface formed on an upper surface of the insulating layer. An additional laminated insulating layer or molding layer may be formed between an outer side portion of the lower surface of the third metal layer and the concave-convex surface. Accordingly, the embodiment can solve the physical reliability problem that the circuit pattern layer is separated from the insulating layer while miniaturizing the line width or space of the circuit pattern layer included in the connection member. In addition, the third metal layer of the circuit pattern layer according to the embodiment may be formed by electroplating the first metal layer and the second metal layer as a seed layer. Accordingly, a surface roughness of a side surface and an upper surface of the third metal layer may be smaller than that of a metal layer formed by the etching method. Through this, the embodiment can reduce a surface roughness of the third metal layer, accordingly, it is possible to minimize a signal transmission loss caused by a skin effect when transmitting a signal of a high frequency band, and thereby improve signal characteristics.

A circuit board of the embodiment may include a first insulating layer and a second insulating layer. The first insulating layer may include a reinforcing member, and the second insulating layer may not include a reinforcing member. In the embodiment, the circuit design of the circuit board can be performed using the number of layers of the second insulating layer while minimizing the number of layers of the first insulating layer. Accordingly, the embodiment can improve a warpage property of the circuit board by using the first insulating layer and reduce a thickness of the circuit board by using the second insulating layer. Through this, the embodiment can reduce a thickness of a circuit board, reduce a thickness of a semiconductor package, and reduce a thickness of an electronic product and/or server to which the semiconductor package is applied. In addition, according to the embodiment, semiconductor devices and connection members may be stably disposed on a circuit board. Accordingly, the embodiment can stably operate a semiconductor device, and furthermore, stably operate an electronic product and/or a server.

In addition, the embodiment may include a first circuit pattern in which at least a portion is buried in upper surface of the first insulating layer. The first circuit pattern may include first and second pads on which semiconductor devices are mounted. In this case, the first pad and the second pad may be used as mounting pads for mounting the first and second semiconductor devices and may be used as terminal pads connected to connection members. Accordingly, the embodiment can reduce a signal transmission distance between the semiconductor device and the connection member, thereby minimizing the signal transmission loss.

In addition, the embodiment may allow at least a portion of a side surface of the first circuit pattern to be supported by a first insulating layer including a reinforcing member. Accordingly, the embodiment can improve an adhesion strength between the first circuit pattern and the first insulating layer, and further improve product reliability.

In addition, a connection member provided in a conventional semiconductor package may be provided in a buried state in a circuit board. For example, a conventional connection member may be embedded in a circuit board. In this case, bending of the connection member may occur according to the warpage property of the circuit board, and thus reliability of the connection member may deteriorate. For example, a coefficient of thermal expansion of the connection member may be different from that of the circuit board, and cracks may occur due to this. Therefore, it causes damage to the fine circuit layer provided on the connection member. In contrast, the connection member of the embodiment may be protected by the first molding layer while being disposed in the first cavity. Furthermore, an additional insulating layer and a circuit pattern may not be provided below the connection member. Accordingly, the embodiment may improve the warpage property of the connection member in various use environments of the circuit board. Accordingly, the embodiment may improve communication performance between the first and second semiconductor devices. In addition, the embodiment may allow at least a portion of the connection member to be exposed to a lower side of the first molding layer. Accordingly, the embodiment can easily dissipate heat generated from the connection member to an outside, thereby improving heat dissipation characteristics of the connection member. Furthermore, the embodiment can improve physical reliability and electrical reliability of the connection member.

In addition, the embodiment may include a second molding layer to protect a post bump and a third molding layer to protect the semiconductor device. The second and third molding layers may include different insulating materials and may have different strengths. Accordingly, the embodiment may stably protect the post bump and the semiconductor device. In addition, the embodiment may allow a process for manufacturing a circuit board to proceed in a state in which the second molding layer is formed. Accordingly, the embodiment can protect the circuit board from being damaged when the connection member is mounted, and further improve connection reliability between the circuit board and the connection member.

Hereinafter, a method of manufacturing a circuit board according to an embodiment will be described.

The method of manufacturing a circuit board according to an embodiment may include manufacturing a connection member 200, manufacturing a circuit board including a cavity, and arranging the connection member 200 in a cavity of the circuit board.

Accordingly, the manufacturing method of the connection member will be firstly described below.

FIGS. 9A to 9H are views for explaining a method of manufacturing a connection member according to an embodiment in a process order.

Referring to FIG. 9A, the embodiment may proceed with a process of preparing a base layer 210 used as a base material for manufacturing a connection member 200. The embodiment may proceed with a process of stacking the insulating layer 220 on the prepared base layer 210. The insulating layer 220 may include a photosensitive material for miniaturization of the circuit pattern layer.

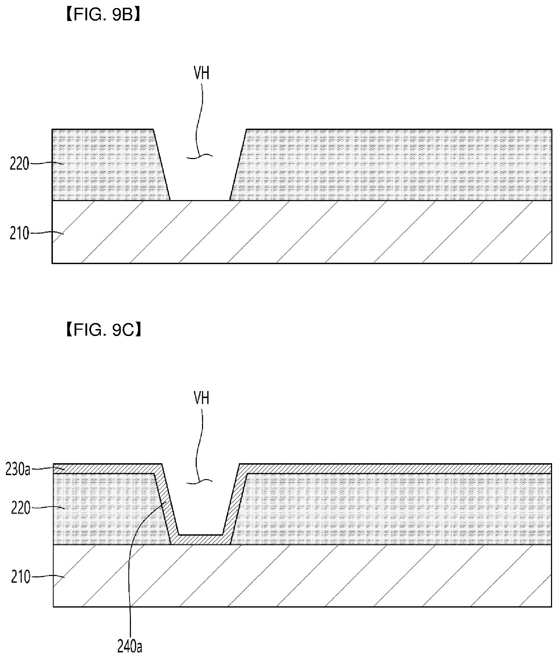

Next, referring to FIG. 9B, the embodiment may proceed with a process of forming a through hole VH in the insulating layer 220. In this case, the insulating layer 220 includes a photosensitive material. Accordingly, the through hole VH may be formed through exposure and development processes. Accordingly, the embodiment can reduce the width of the through hole (VH) compared to forming the through hole by a laser process, so that miniaturization of the through electrode 240 may be possible.

Next, referring to FIG. 9C, the embodiment may proceed with a process of forming a first metal layer on the upper surface of the insulating layer 220 and the inner wall of the through hole VH. Preferably, the embodiment may proceed with a process of forming the first metal layer 230a of the circuit pattern layer 230 on the upper surface of the insulating layer 220 and the first metal layer 240a of the through electrode 240 on the inner wall of the through hole VH.

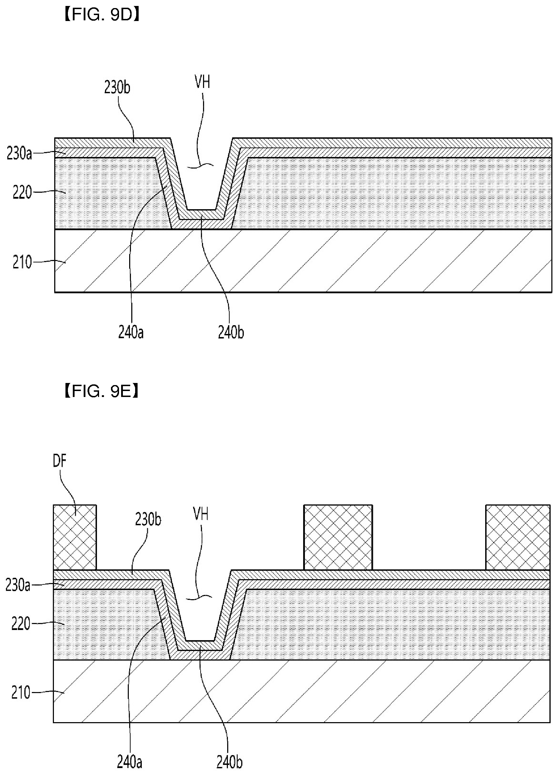

Next, referring to FIG. 9D, the embodiment may proceed with a process of forming a second metal layer on the first metal layer. Preferably, the embodiment may proceed with a process of forming a second metal layer 230b of the circuit pattern layer 230 on the first metal layer 230a of the circuit pattern layer 230 and a process of forming the second metal layer 240b of the through electrode 240 on the first metal layer 240a of the through electrode 240.

Next, referring to FIG. 9E, the embodiment may proceed with a process of forming a mask DF on the second metal layer. The mask DF may include an opening.

Preferably, the mask DF may include an opening (not shown) vertically overlapping the through hole VH and vertically overlapping a region where the third metal layer 230c is to be disposed on the top surface of the second metal layer 230b of the circuit pattern layer 230.

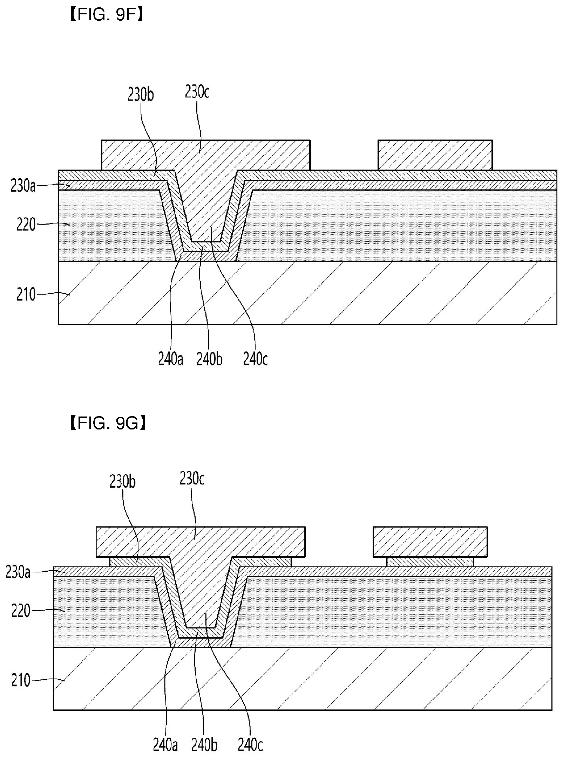

Next, referring to FIG. 9F, the embodiment may proceed with a process of electroplating the first metal layer and the second metal layer as a seed layer to fill the opening of the mask DF and the through hole VH. The third metal layer 240c of the through electrode 240 may be formed in the through hole VH by the electroplating process. In addition, the third metal layer 230c of the circuit pattern layer 230 may be formed in a region vertically overlapping the opening of the mask DF on the upper surface of the second metal layer 230b of the circuit pattern layer 230. When the formation process of the third metal layer 230c of the circuit pattern layer 230 and the third metal layer 240c of the through electrode 240 is completed, the embodiment may proceed with a process of removing the mask DF.

Next, as shown in FIG. 9G, the embodiment may proceed with a first etching process of removing a region of the second metal layer 230b of the circuit pattern layer 230 that does not vertically overlap with the third metal layer 230c. In this case, a portion of the region vertically overlapping the third metal layer 230c may be removed in the first etching process of removing the second metal layer 230b. In this case, the metal material constituting the first metal layer 230a is different from the metal material constituting the second metal layer 230b. Accordingly, the first metal layer 230a may not be removed in the first etching process.

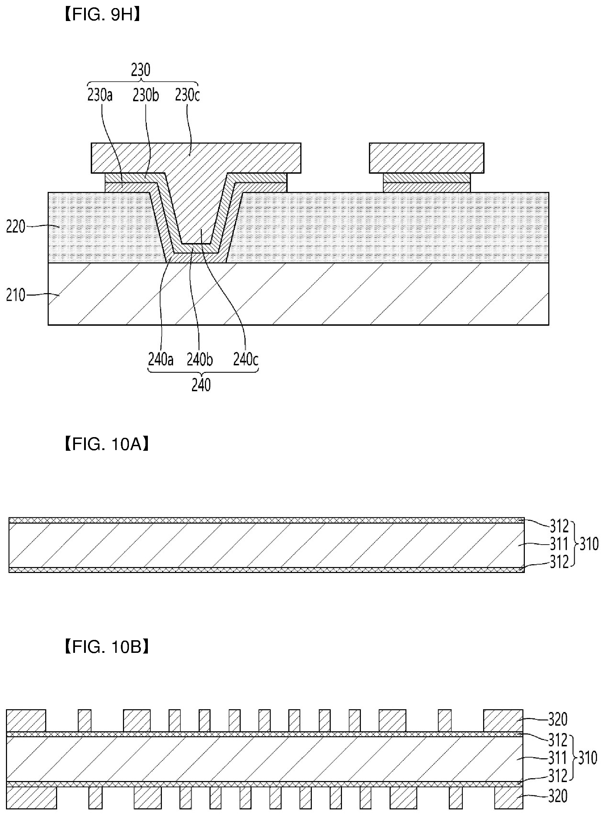

Next, as shown in FIG. 9H, the embodiment may proceed with a second etching process of removing a region of the first metal layer 230a of the circuit pattern layer 230 that does not vertically overlap the second metal layer 230b and the third metal layer 230c. In this case, as described above, a portion of the region vertically overlapping with the third metal layer 230c is removed in the first etching process of etching the second metal layer 230b. Correspondingly, a portion of a region of the first metal layer 230a vertically overlapping the third metal layer 230c (However, it does not overlap vertically with the second metal layer 230b) may also be removed in the second etching process of etching the first metal layer 230a. Accordingly, a recess or stepped portion 230U may be provided at the outer side portion of the lower surface of the circuit pattern layer 230 in the embodiment.

Next, a process for manufacturing the circuit board will be described.

FIGS. 10A to 10V are views for explaining a method of manufacturing a circuit board shown in FIG. 1 in a process order.

Referring to FIG. 10A, the circuit board may be manufactured using the ETS method. To this end, the embodiment may proceed with a process of preparing a basic material for manufacturing a circuit board. To this end, the embodiment may prepare a carrier board 310. The carrier board 310 may include a carrier insulating layer 311 and a carrier metal layer 312 disposed on at least one surface of the carrier insulating layer 311.

In addition, the embodiment may proceed with a process of simultaneously manufacturing two circuit boards on both sides of the carrier board 310 using the carrier metal layer 312 disposed on both sides of the carrier board 310.

The carrier metal layer 312 may be formed by electroless plating on the carrier insulating layer 311. In addition, the embodiment may use CCL (Copper Clad Laminate) as the carrier board 310.

Subsequently, the embodiment may proceed with a process of forming a first mask 320 on the carrier metal layer 312 as shown in FIG. 10B. In this case, the first mask 320 may be formed to cover the entire carrier metal layer 312, and may include an opening (not shown) partially exposing the surface of the carrier metal layer 312 formed through a later opening process. That is, the first mask 320 may include an opening (not shown) opening a region in which the first circuit pattern 121 is to be formed on the surface of the carrier metal layer 312.

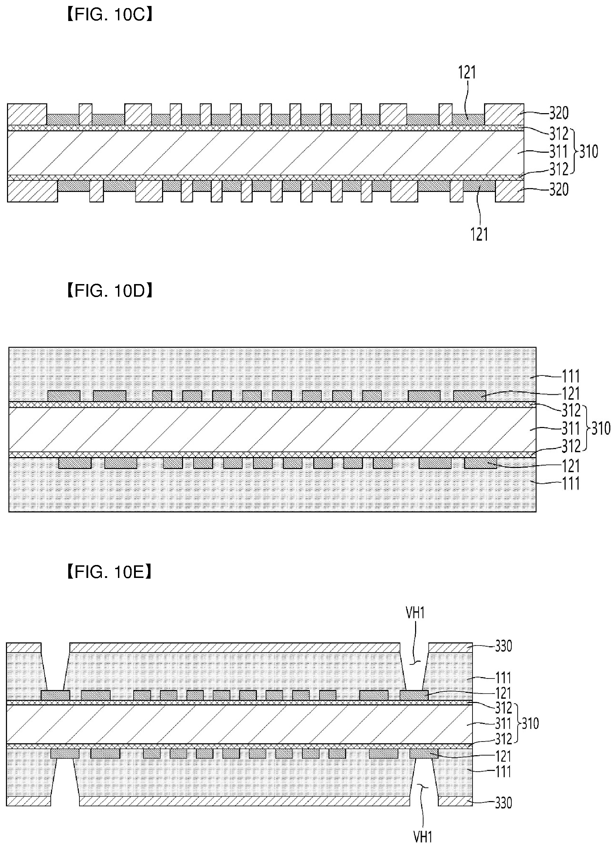

Subsequently, the embodiment may proceed with a process of forming a first circuit pattern 121 filling an opening of the first mask 320 by performing electrolytic plating using the carrier metal layer 312 as a seed layer as shown in FIG. 10C.

Subsequently, the embodiment may proceed with a process of removing the first mask 320 disposed on the carrier metal layer 312 as shown in FIG. 10D. In addition, the embodiment may proceed with a process of forming the first insulating layer 111 covering the first circuit pattern 121 on the carrier metal layer 312. The first insulating layer 111 may include prepreg.

Next, the embodiment may proceed with a process of forming a through hole VH1 in the first insulating layer 111 as shown in FIG. 10E. The through hole VH1 may be formed through a laser process to open the resin and reinforcing member constituting the first insulating layer 111. To this end, the embodiment may proceed with a process of forming a second mask 330 (for example, a laser mask) for forming the through hole VH1 on the first insulating layer 111 through the laser process.

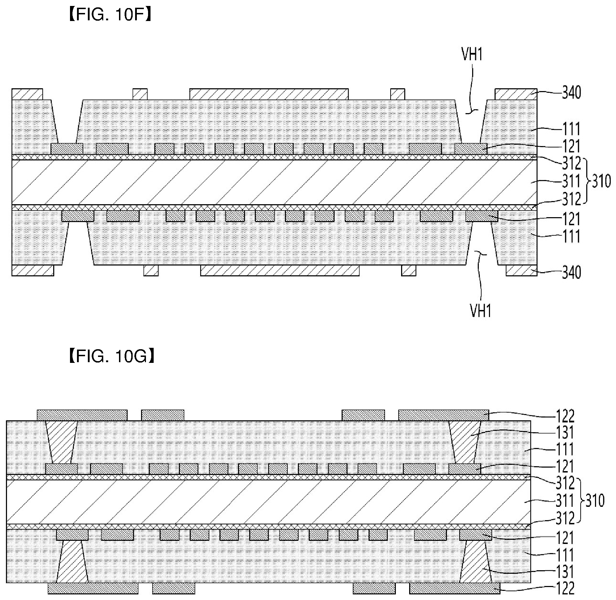

Next, the embodiment may proceed with a process of forming a third mask 340 on the surface of the first insulating layer 111 and the through hole VH1 as shown in FIG. 10F. In this case, the third mask 340 may include at least one opening (not shown). For example, the third mask 340 may include an opening exposing a region where the first through electrode 131 is to be formed and an opening exposing a region where the second circuit pattern 122 is to be formed.

Next, the embodiment proceeds with a process of forming the first through electrode 131 and the second circuit pattern 122 by performing electrolytic plating to fill the opening of the third mask 640 as shown in FIG. 10G. When the first through electrode 131 and the second circuit pattern 122 are formed, the embodiment may proceed with a process of removing the third mask 640.

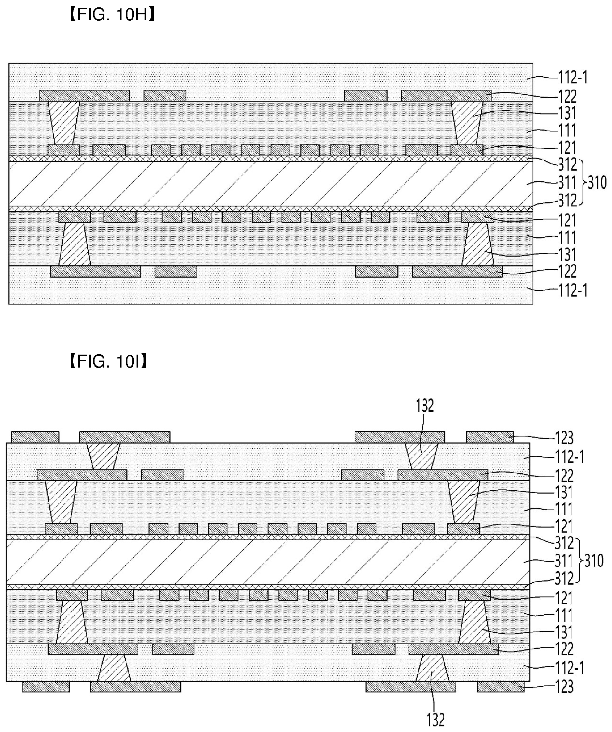

Next, the embodiment may proceed with a process of forming a first layer 112-1 on the first insulating layer 111 as shown in FIG. 10H. In this case, the first layer 112-1 may be composed of RCC. The RCC may include a copper foil layer (not shown), and the copper foil layer may be removed through an etching process.

Next, the embodiment may proceed with a process of forming a second through electrode 132 and a third circuit pattern 123 on the first layer 112-1 as shown in FIG. 10I.

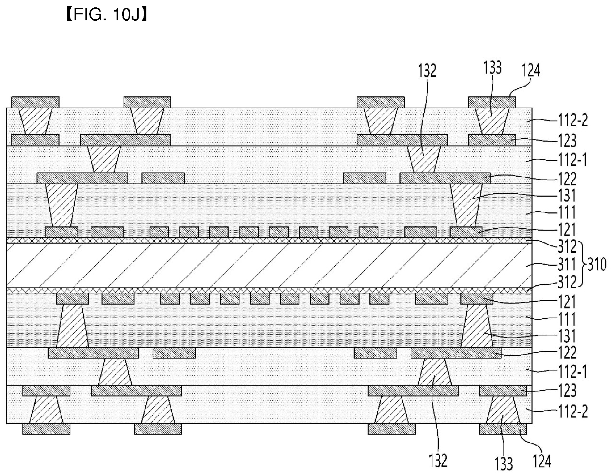

Next, the embodiment may proceed with a process of forming a second layer 112-2 on the first layer 112-1 as shown in FIG. 10J. The embodiment may proceed with a process of forming the third through electrode 133 and the fourth circuit pattern 124 on the second layer 112-2.

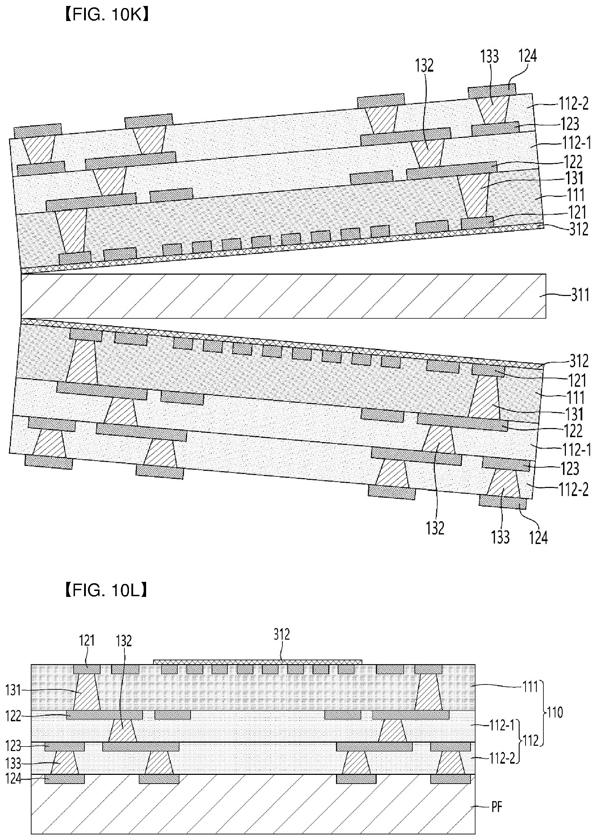

Next, when the manufacturing of the circuit board is completed as described above, the embodiment may proceed with a process of separating the manufactured circuit boards from both sides of the carrier board 310 from one another as shown in FIG. 10K. In this case, the embodiment may allow easy separation of the carrier insulating layer 311 and the carrier metal layer 312 of the carrier board 310. Accordingly, the separation process proceeds, so that the carrier metal layer 312 may remain on the outermost side of the circuit board. The carrier metal layer 312 is a seed layer used to form the first circuit pattern 121 as described above.

Next, referring to FIG. 10L, the embodiment may proceed with a process of etching and removing the carrier metal layer 312 used as the seed layer. To this end, the embodiment may proceed with a process of forming the first protective film PF on the lower surface of the second layer 112-2. The first protective film PF may be a protective layer for protecting the second layer 112-2 and the fourth circuit pattern 124 in subsequent processes performed on the upper side of the first insulating layer 111.

Meanwhile, the embodiment may include a process of forming a cavity during a manufacturing process of a circuit board. The cavity may include a first cavity C1 and a second cavity C2. In this case, the first cavity C1 and the second cavity C2 may be formed through a laser process. And, a laser stopper for forming a cavity to a desired depth must exist in order to proceed with the laser process. In this case, the embodiment uses a part of the carrier metal layer 312 as the laser stopper. Accordingly, the embodiment can omit a process of additionally forming the laser stopper, thereby simplifying the manufacturing process and thereby reducing the manufacturing cost.

Accordingly, when the etching process of the carrier metal layer 312 proceeds, the embodiment may allow the remaining portion to be removed while remaining a portion positioned in the region where the first cavity C1 and the second cavity C2 are to be formed. Hereinafter, the portion remaining without being removed among the carrier metal layer 312 will be described as a 'stopper'.

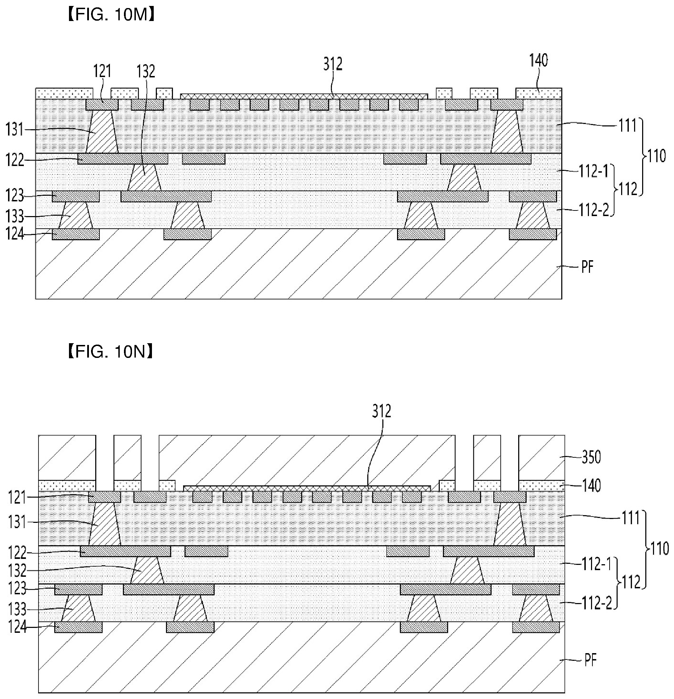

Next, the embodiment may proceed with a process of forming a first protective layer 140 on the upper surface of the first insulating layer 111 as shown in FIG. 10M. In this case, the first protective layer 140 may be disposed on an entire region of the upper surface of the first insulating layer 111. In addition, the embodiment may proceed with a process of forming an opening exposing a region corresponding to the third pad 121-3 by processing the first protective layer 140. In this case, the first protective layer 140 may expose the first region R1 of the upper surface of the first insulating layer 111. Here, the first region R1 may be a region where the stopper 312 is disposed.

Next, the embodiment may proceed with a process of forming a fourth mask 350 on the upper surface of the first protective layer 140 as shown in FIG. 10N. In this case, the fourth mask 350 may include an opening exposing an upper surface of the third pad 121-3 exposed through the first protective layer 140.

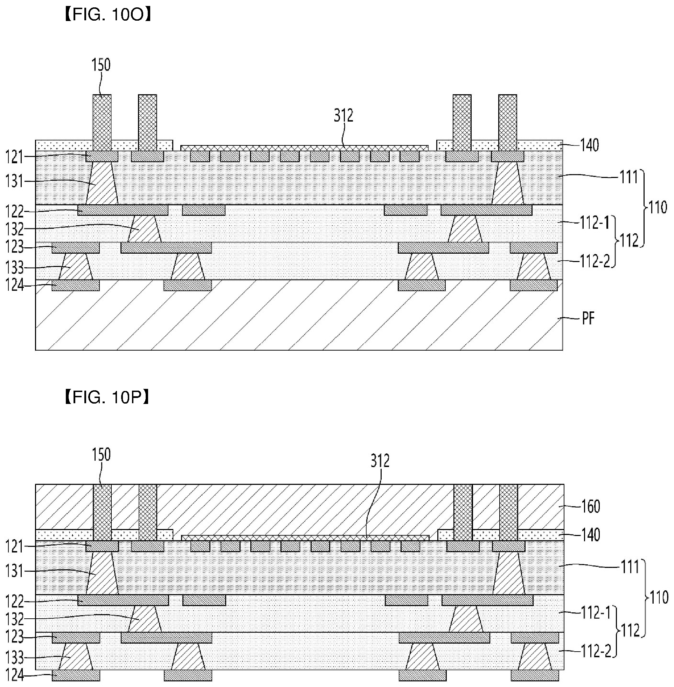

Next,, the embodiment may proceed a process of forming a post bump 150 on the upper surface of the third pad 121-3 exposed through the opening of the fourth mask 350 and the opening of the first protective layer 140 as shown in FIG. 10O.

Next, the embodiment may proceed with a process of forming a second molding layer 160 on the first protective layer 140 and the stopper 312 as shown in FIG. 10P. The second molding layer 160 may be formed to protect an upper side of the first insulating layer 111 during an insertion process of the connection member 200 while protecting the post bump 150.

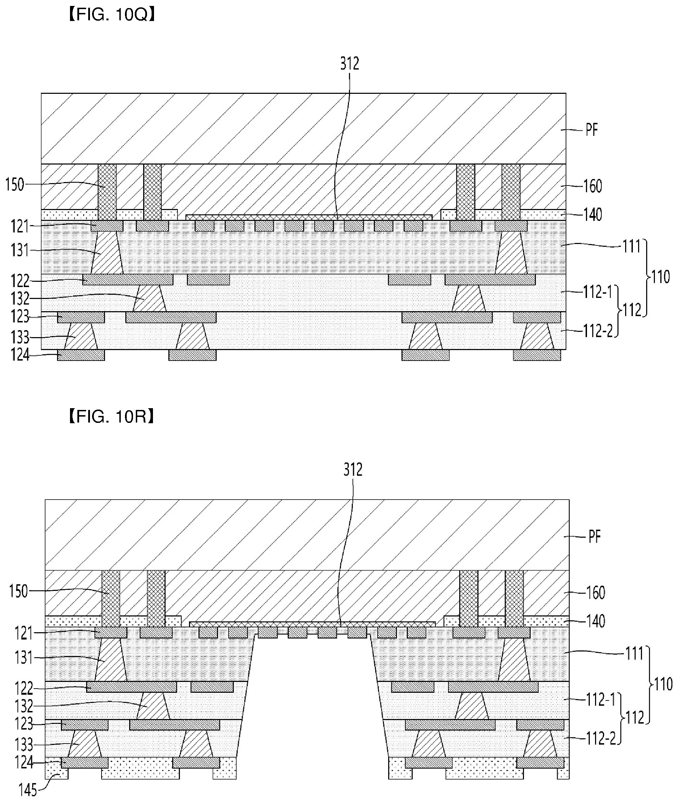

Next, the embodiment may proceed with a process of removing the first protective film PF as shown in FIG. 10Q. Thereafter, the embodiment may proceed with a process of forming a second protective film PF on the second molding layer 160. In addition, the embodiment may proceed with a process of forming a second protective layer 145 on the lower surface of the second layer 112-2. The second protective layer 145 may include an opening exposing a region where the first cavity C1 is to be formed and a lower surface of the terminal pad of the fourth circuit pattern 122.

Next, the embodiment may proceed with a process of forming the first cavity C1 by processing the first insulating layer 111 and the second insulating layer 112 as shown in FIG. 10R. The first cavity C1 may expose lower surfaces of the first-second pad 121-12 and lower surfaces of the second-second pad 121-22 among the first circuit patterns 121 disposed on the upper surface of the first insulating layer 111. In this case, the embodiment can adjust the laser processing conditions, so that a part of the first insulating layer 111 disposed on the side surfaces of the first-second pad 121-12 and second-second pad 121-22 remains.

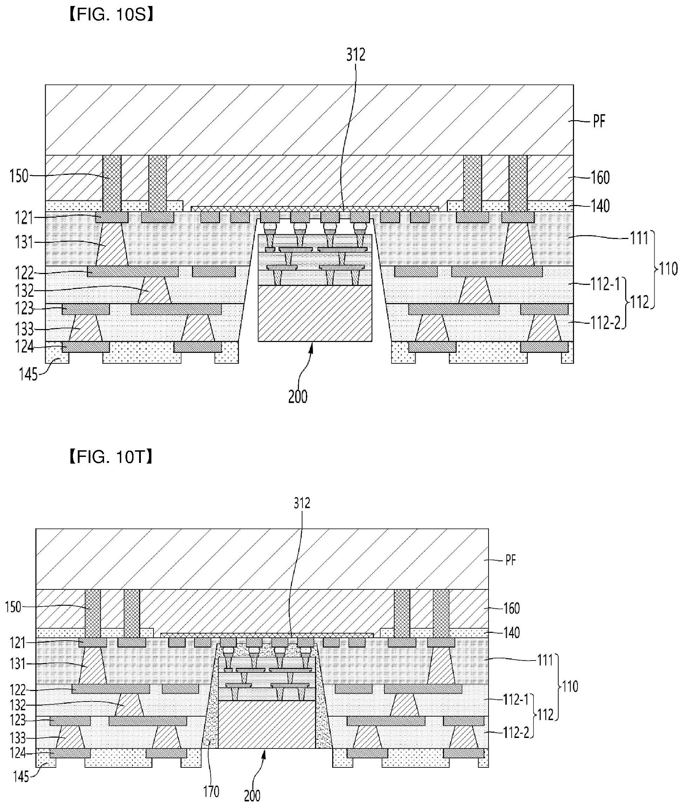

Next, the embodiment may proceed with a process of inserting or attaching the connection member 200 manufactured in the previous process into the first cavity C1 as shown in FIG. 10S. To this end, the embodiment may proceed with a process of attaching the first connection portion 201 to the uppermost circuit pattern layer among the circuit pattern layers 230 of the connection member 200. After that, the embodiment may proceed with a process of attaching the connection member 200 to the lower surfaces of the first-second pad 121-12 and the lower surfaces of the second-second pad 121-22 exposed through the first cavity C1 by using the first connection portion 201.

Next, the embodiment may proceed with a process of forming a first molding layer 170 filling the first cavity C1 as shown in FIG. 10T. The first molding layer 170 may serve to protect the connection member 200 disposed in the first cavity C1. As shown in the drawing, the first molding layer 170 may expose the lower surface of the base layer 210 of the connection member 200. However, the embodiment is not limited thereto, and the first molding layer 170 may mold all of the base layer 210 of the connection member 200.

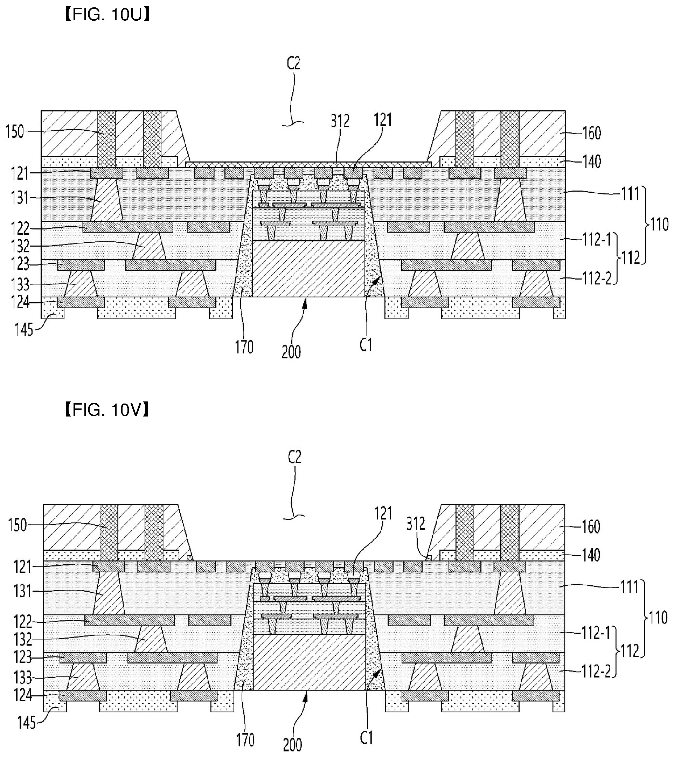

Next, the embodiment may proceed with a process of removing the second protective film PF as shown in FIG. 10U. Thereafter, the embodiment may proceed with a process of forming the second cavity C2 by laser processing the second molding layer 160. In this case, a stopper 312 is formed in a region where the second cavity C2 is to be formed, and the embodiment may remove the region where the stopper 312 is formed in the second molding layer 160, thus, the second cavity C2 may be formed. When the second cavity C2 is formed, the stopper 312 buried in the second molding layer 160 may be exposed.

In this case, the width of the stopper 312 may be greater than the width of the lower surface of the second cavity C2. Accordingly, the upper surface of at least a portion of the stoppers 312 may not be exposed through the second cavity C2.

Next, the embodiment may proceed with a process of etching and removing the stopper 312 exposed through the second cavity C2 as the second cavity C2 is formed as shown in FIG. 10V. Accordingly, the embodiment may allow the upper surfaces of the first pad 121-1 and the second pad 121-2 of the first circuit pattern 121 to be exposed through the second cavity C2.

In this case, at least a part of the stopper 312 may remain between the first insulating layer 111 and the second molding layer 160. However, the embodiment is not limited thereto, and an additional process for completely removing the stopper may be performed.

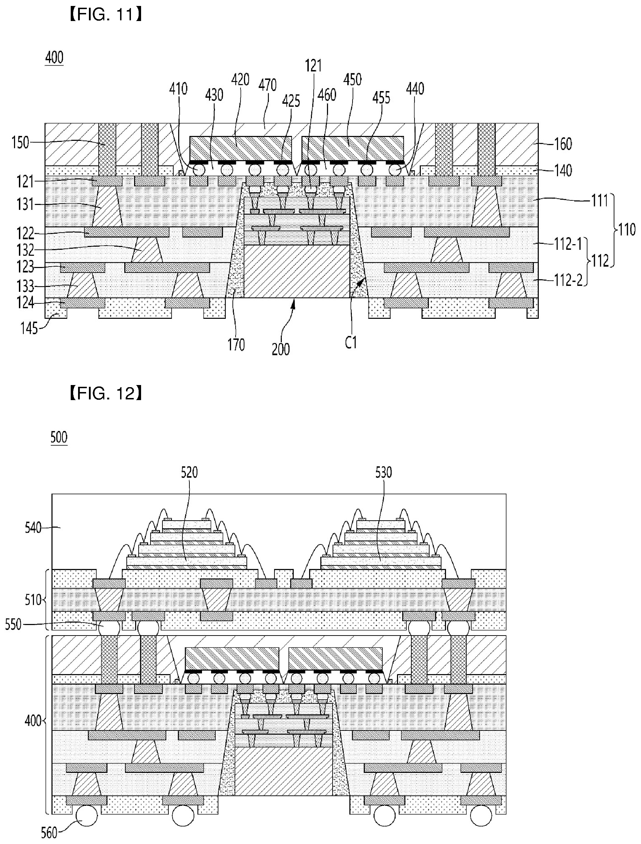

FIG. 11 is a view showing a first semiconductor package according to an embodiment.

A first semiconductor package may refer to a first package in which first and second semiconductor devices are mounted on the circuit board shown in FIG. 1.

Referring to FIG. 11, the embodiment may manufacture a first semiconductor package 400 by mounting first and second semiconductor devices on the circuit board shown in FIG. 1.

The first semiconductor package 400 may include a circuit board and a first semiconductor device 420 and a second semiconductor device 450 mounted on the circuit board. The circuit board has already been described above, and thus a detailed description thereof will be omitted.

The semiconductor package may include the first circuit pattern 121 disposed on an outermost side of the circuit board. The first circuit pattern 121 may include a first pad 121-1 and a second pad 121-2.

In addition, the first semiconductor package 400 may include a second connection portion 410 disposed on an upper surface of the first pad 121-1. In addition, the first semiconductor package 400 may include a third connection portion 440 disposed on an upper surface of the second pad 121-2.

The second connection portion 410 and the third connection portion 440 may have the same shape or may have different shapes.

For example, the second connection portion 410 and the third connection portion 440 may have a hexahedral shape. For example, a cross section of each of the second connection portion 410 and the third connection portion 440 may include a rectangular shape. A cross section of each of the second connection portion 410 and the third connection portion 440 may include a rectangle or a square. For example, the second connection portion 410 and the third connection portion 440 may have a spherical shape. For example, a cross section of each of the second connection portion 410 and the third connection portion 440 may include a circular shape or a semicircular shape. For example, a cross section of each of the second connection portion 410 and the third connection portion 440 may partially or entirely include a rounded shape. Cross-sectional shapes of the second connection portion 410 and the third connection portion 440 may be flat on one side and curved on the other side. The second connection portion 410 and the third connection portion 440 may be solder balls, but are not limited thereto.

An embodiment may include a first semiconductor device 420 disposed on the second connection portion 410. The first semiconductor device 420 may be a first processor chip. For example, the first semiconductor device 420 may be an application processor (AP) chip of any one of a central processor (eg, CPU), a graphic processor (eg, GPU), a digital signal processor, a cryptographic processor, a microprocessor, and a microcontroller. A terminal 425 of the first semiconductor device 420 may be electrically connected to the first pad 121-1 through the second connection portion 410.

In addition, the embodiment may include a second semiconductor device 450 disposed on the third connection portion 440. The second semiconductor device 450 may be a second processor chip or a memory chip. A terminal 455 of the second semiconductor device 450 may be electrically connected to the second pad 121-2 through the third connection portion 440.

Meanwhile, the first semiconductor device 420 and the second semiconductor device 450 may be separated from each other by a predetermined separation width on the circuit board. For example, a separation width between the first semiconductor device 420 and the second semiconductor device 450 may be 150 µm or less. For example, a separation width between the first semiconductor device 420 and the second semiconductor device 450 may be 120 µm or less. For example, a separation width between the first semiconductor device 420 and the second semiconductor device 450 may be 100 µm or less.

Preferably, a separation width between the first semiconductor device 420 and the second semiconductor device 450 may have a range of 60 µm to 150 µm. Preferably, a separation width between the first semiconductor device 420 and the second semiconductor device 450 may have a range of 70 µm to 120 µm. Preferably, a separation width between the first semiconductor device 420 and the second semiconductor device 450 may have a range of 80 µm to 110 µm. When the separation width between the first semiconductor device 420 and the second semiconductor device 450 is less than 60 µm, a region in which the connection member 200 is disposed may not be secured. In addition, when the separation width between the first semiconductor device 420 and the second semiconductor device 450 is less than 60 µm, interference between the first semiconductor device 420 and the second semiconductor device 450 occurs, and accordingly, there is a problem in operation reliability of the first semiconductor device 420 or the second semiconductor device 450.

When the separation width between the first semiconductor device 420 and the second semiconductor device 450 is greater than 150 µm, a distance between the first semiconductor device 420 and the second semiconductor device 450 increases, and thus signal transmission loss may increase. When the separation width between the first semiconductor device 420 and the second semiconductor device 450 is greater than 150 µm, a volume of the first semiconductor package 400 may increase.

The first semiconductor package 400 may include a first fillet layer 430 and a second fillet layer 460. The first fillet layer 430 may be disposed surrounding the terminal 425 of the first semiconductor device 420. The first fillet layer 430 may prevent foreign substances (eg, moisture) from penetrating into a space between the circuit board and the first semiconductor device 420. The second fillet layer 460 may be disposed surrounding the terminal 455 of the second semiconductor device 450. The second fillet layer 460 may prevent foreign substances (eg, moisture) from penetrating into a space between the circuit board and the second semiconductor device 450.

The first semiconductor package 400 may include a third molding layer 470. The third molding layer 470 may be disposed to cover the first semiconductor device 420 and the second semiconductor device 450. For example, the third molding layer 470 may be EMC (Epoxy Mold Compound) formed to protect the mounted first semiconductor device 420 and the second semiconductor device 450, but it is not limited thereto. The third molding layer 470 may be disposed while filling the second cavity C2 of the circuit board.

The third molding layer 470 may have a low dielectric constant in order to stably protect the first semiconductor device 420 and the second semiconductor device 450 while improving heat dissipation property. For example, the dielectric constant (Dk) of the third molding layer 470 may be 0.2 to 10. For example, the dielectric constant (Dk) of the third molding layer 470 may be 0.5 to 8. For example, the dielectric constant (Dk) of the third molding layer 470 may be 0.8 to 5. Accordingly, the embodiment may allow the third molding layer 470 to have a low dielectric constant, so that heat dissipation characteristics of heat generated from the first semiconductor device 420 and/or the second semiconductor device 450 may be improved.

In addition, the second molding layer 160 and the third molding layer 470 may include different materials. The second molding layer 160 is used to protect the post bump 150, and the third molding layer 470 is used to protect the first semiconductor device 420 and the second semiconductor device 450. Accordingly, the second molding layer 160 and the third molding layer 470 may have different strengths. As described above, the embodiment may allow the second molding layer 160 and the third molding layer 470 to include different materials, so that the post bump 150 and the first semiconductor device 420 and the second semiconductor device 450 may be stably protected. The embodiment may allow the manufacturing process of the circuit board to proceed in a state in which the second molding layer 160 is formed, damage to the circuit board can be protected when the connection member 200 is mounted, so that connection reliability between the circuit board and the connection member 200 can be improved.

FIG. 12 is a view showing a second semiconductor package according to an embodiment.

Referring to FIG. 12, the second semiconductor package 500 may have a structure in which a second package corresponding to a memory package is coupled to the first semiconductor package 400 of FIG. 11.

To this end, the second semiconductor package 500 may include a memory package.

The memory package includes a memory substrate 510. The memory substrate 510 may include at least one insulating layer, a via layer, a circuit pattern layer, and a protective layer. The memory substrate 510 is substantially the same as a third substrate of a comparative example, and thus a detailed description thereof will be omitted.

The memory package includes a memory chip mounted on the memory substrate 510. For example, the memory package may include a first memory chip 520 and a second memory chip 530 mounted on the memory substrate 510 at regular intervals.

In addition, the memory package may include a fourth molding layer 540 disposed on the memory substrate 510 and molding the first memory chip 520 and the second memory chip 530.

Meanwhile, the second semiconductor package 500 may include a fourth connection portion 550 disposed on the post bump 150 of the first semiconductor package 400. The memory package may be attached to the first semiconductor package 400 through the fourth connection portion 550.

In addition, the second semiconductor package 500 includes a fifth connection portion 560 disposed on the fourth circuit pattern 124 exposed through the second protective layer 145 of the circuit board. The fifth connection portion 560 may be an adhesive ball connected to the main board of the electronic device.

According to one example, the semiconductor package comprises a first
insulating layer including a cavity; a connection member buried in the cavity of the first insulating layer; and a molding layer buried in the cavity and surrounding the connection member. A width of the molding layer gradually decreases along a direction from a lower surface of the first insulating layer to an upper surface of the first insulating layer.

The semiconductor package may have one or more of the following :
- it further comprises a first circuit pattern disposed on the first insulating layer and including a first electrode pattern overlapping the connection member in a vertical direction and a second electrode pattern not overlapping the connection member in the vertical direction; a post bump disposed on the second electrode pattern of the first circuit pattern; and a through electrode buried in the first insulating layer, overlapped with the connection member in a horizontal direction, and overlapped with the post bump in a vertical direction. The connection member has a pad portion connected to the first electrode pattern. A width of the through electrode is greater than a width of the pad portion.
- a width of the through electrode changes in the vertical direction. The width of the pad portion is smaller than a width of a region having a smallest width in an entire region of the through electrode.
- a width of the first electrode pattern is smaller than a width of the second electrode pattern.
- the pad portion of the connection member includes: a first metal layer;
   a second metal layer disposed on the first metal layer; and a third metal layer disposed on the second metal layer; wherein a lower surface of the third metal layer includes a first portion in contact with the second metal layer and a second portion not in contact with the second metal layer.
- a width of the lower surface of the third metal layer is greater than a width of an upper surface of the second metal layer.
- a width of an upper surface of the third metal layer is greater than a width of an upper surface of the third metal layer.
- a width of the third metal layer increases from a lower surface of the third metal layer toward an upper surface of the third metal layer.
- the connection member includes an insulating member having a concave-convex surface protruding toward the third metal layer.
- the second portion of the lower surface of the third metal layer does not contact the concave-convex surface of the insulating member.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

Features, structures, effects, etc. described in the above embodiments are included in at least one embodiment, and it is not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and variations should be interpreted as being included in the scope of the embodiments.

In the above, the embodiment has been mainly described, but this is only an example and does not limit the embodiment, and those of ordinary skill in the art to which the embodiment pertains will appreciate that various modifications and applications not illustrated above are possible without departing from the essential characteristics of the present embodiment. For example, each component specifically shown in the embodiment can be implemented by modification. And the differences related to these modifications and applications should be interpreted as being included in the scope of the embodiments set forth in the appended claims.

## Claims

1. A circuit board comprising:
a first insulating layer including a first cavity;
a connection member buried in the first cavity of the first insulating layer;
a first circuit pattern disposed on the first insulating layer and including a first electrode pattern overlapping the connection member in a vertical direction and a second electrode pattern not overlapping the connection member in the vertical direction;
a post bump disposed on the second electrode pattern of the first circuit pattern;
wherein the connection member includes a pad portion connected to the first electrode pattern,
wherein the pad portion of the connection member includes:
a first metal layer;
a second metal layer disposed on the first metal layer; and
a third metal layer disposed on the second metal layer;
wherein a lower surface of the third metal layer includes a first portion in contact with the second metal layer and a second portion not in contact with the second metal layer.

2. The circuit board of claim 1, further comprising:
a through electrode buried in the first insulating layer, disposed to overlap with the connection member in a horizontal direction, and overlapped with the post bump in a vertical direction, and
wherein a lateral width of the through electrode is greater than a lateral width of the pad portion.

3. The circuit board of claim 1 or 2, wherein a width of the lower surface of the third metal layer is greater than a width of an upper surface of the second metal layer.

4. The circuit board of any one of claims 1 to 3, wherein a width of an upper surface of the third metal layer is greater than a width of an upper surface of the second metal layer.

5. The circuit board of any one of claims 1 to 4, wherein a width of the third metal layer increases from a lower surface of the third metal layer toward an upper surface of the third metal layer.

6. The circuit board of any one of claims 1 to 5, wherein the connection member includes an insulating member having a concave-convex surface protruding toward the third metal layer.

7. The circuit board of claim 6, wherein the second portion of the lower surface of the third metal layer does not contact the concave-convex surface of the insulating member.

8. The circuit board of claim 7, wherein a height of the concave-convex surface corresponds to a surface roughness value of an upper surface of the insulating member.

9. The circuit board of claim 8, wherein the surface roughness value satisfies a range of 8 nm to 40 nm.

10. The circuit board of any one of claims 1 to 9, wherein a thickness of the first metal layer has a range of 30 nm to 100 nm,
wherein a thickness of the second metal layer has a range of 100 nm to 500 nm, and
wherein a thickness of the third metal layer has a range of 2um to 7um.

11. The circuit board of claim 10, wherein the thickness of the third metal layer is 75% to 98% of a thickness of the pad portion.

12. The circuit board of any one of claims 1 to 11, wherein a surface roughness of at least one of an upper surface and a side surface of the third metal layer is smaller than a surface roughness of each of a side surface of the first metal layer and a side surface of the second metal layer.

13. The circuit board of any one of claims 1 to 12, further comprising:
a first molding layer buried in the first cavity and surrounding the connection member;
a second molding layer disposed on the first insulating layer and including a second cavity; and
a semiconductor device disposed in the second cavity,
wherein a lower surface of the first electrode pattern is exposed through the first cavity and an upper surface of the first electrode pattern is exposed through the second cavity,
wherein the connection member is attached on the lower surface of the first electrode pattern, and
wherein the semiconductor device is attached on the upper surface of the first electrode pattern.
